# EUROPEAN PATENT APPLICATION

(11) **EP 4 451 820 A1**
(43) Date of publication of application: **23.10.2024**
(21) Application number: 24165724.6
(22) Date of filing: 24.03.2024
(51) Int. Cl.: H10B 43/10, H10B 43/27, H10B 43/50

(54) **SEMICONDUCTOR DEVICES AND DATA STORAGE SYSTEMS INCLUDING THE SAME**

(30) Priority: 19.04.2023 KR 20230051464
(71) Applicant: Samsung Electronics Co., Ltd., Suwon-si, Gyeonggi-do 16677 (KR)
(72) Inventor: LEE, Hyemi, 16677 Suwon-si (KR); KIM, Seungyoon, 16677 Suwon-si (KR); KIM, Heesuk, 16677 Suwon-si (KR); LEE, Sangjae, 16677 Suwon-si (KR); LEE, Jaehoon, 16677 Suwon-si (KR); LIM, Juyoung, 16677 Suwon-si (KR); CHUNG, Minkyu, 16677 Suwon-si (KR); CHUN, Sanghun, 16677 Suwon-si (KR); HAN, Jeehoon, 16677 Suwon-si (KR)
(74) Representative: Marks & Clerk LLP

(57) **Abstract**

A semiconductor device includes a plate layer, gate electrodes and interlayer insulating layers alternately stacked on the plate layer in a first direction perpendicular to an upper surface of the plate layer and forming a first stack structure and a second stack structure on the first stack structure, a channel structure penetrating through the gate electrodes and extending in the first direction, and a contact plug extending in the first direction and electrically connected to one of the gate electrodes, wherein the second stack structure includes a first gate electrode on a lowermost portion, a first interlayer insulating layer on the first gate electrode, and a second interlayer insulating layer on the first interlayer insulating layer, and the first interlayer insulating layer has a first thickness, and the second interlayer insulating layer has a second thickness smaller than the first thickness.

## Description

### BACKGROUND

### 1. Field

Example embodiments of the present disclosure relate to semiconductor devices and data storage systems including the same.

### 2. Description of the Related Art

A semiconductor device able to store high-capacity data in a data storage system requiring data storage has been necessary. Accordingly, a method for increasing data storage capacity of a semiconductor device has been researched. For example, as a method for increasing data storage capacity of a semiconductor device, a semiconductor device including memory cells disposed three-dimensionally, instead of memory cells disposed two-dimensionally, has been suggested.

### SUMMARY

Embodiments are directed to a semiconductor device, including a first semiconductor structure including a substrate, circuit devices on the substrate, and circuit interconnection lines on the circuit devices, and a second semiconductor structure on the first semiconductor structure and having first and second regions, wherein the second semiconductor structure includes a plate layer, gate electrodes stacked and spaced apart from each other on the plate layer in a first direction perpendicular to an upper surface of the plate layer, interlayer insulating layers alternately disposed with the gate electrodes, channel structures penetrating through the gate electrodes and the interlayer insulating layers in the first region, extending in the first direction, and each including a channel layer, and contact plugs penetrating through the gate electrodes and the interlayer insulating layers in the second region, extending in the first direction, and electrically connecting the gate electrodes to a portion of the circuit interconnection lines, respectively, each of the channel structures includes first and second channel portions stacked in order from a lower portion, each of the contact plugs includes first and second contact portions stacked in order from a lower portion, a first interfacial surface between the first channel portion and the second channel portion is on a first level, and a second interfacial surface between the first contact portion and the second contact portion is on a second level higher than the first level, and the second interfacial surface is in a first interlayer insulating layer among the interlayer insulating layers.

Embodiments are directed to a semiconductor device, including a plate layer, gate electrodes and interlayer insulating layers alternately stacked on the plate layer in a first direction perpendicular to an upper surface of the plate layer and forming a first stack structure and a second stack structure on the first stack structure, a channel structure penetrating through the gate electrodes and extending in the first direction, and a contact plug extending in the first direction and electrically connected to one of the gate electrodes, wherein the second stack structure includes a first gate electrode on a lowermost portion, a first interlayer insulating layer on the first gate electrode, and a second interlayer insulating layer on the first interlayer insulating layer, and the first interlayer insulating layer has a first thickness, and the second interlayer insulating layer has a second thickness smaller than the first thickness.

Embodiments are directed to a data storage system, including a semiconductor storage device including a first semiconductor structure including circuit devices, a second semiconductor structure on one surface of the first semiconductor structure, and an input/output pad electrically connected to the circuit devices, and a controller electrically connected to the semiconductor storage device through the input/output pad and configured to control the semiconductor storage device, wherein the second semiconductor structure includes a plate layer, gate electrodes and interlayer insulating layers alternately stacked on the plate layer in a first direction perpendicular to an upper surface of the plate layer and forming a first stack structure and a second stack structure on the first stack structure, a channel structure penetrating through the gate electrodes and extending in the first direction, and a contact plug penetrating through the gate electrodes, extending in the first direction, and electrically connected to one of the gate electrodes, the channel structure includes a first channel portion penetrating through the first stack structure and a second channel portion penetrating through the second stack structure, the contact plug includes a first contact portion penetrating through the first stack structure and a second contact portion penetrating through at least a portion of the second stack structure, and a first interfacial surface between the first channel portion and the second channel portion is on a first level, and a second interfacial surface between the first contact portion and the second contact portion is on a second level higher than the first level.

At least some of the above and other features of the invention are set out in the claims.

### BRIEF DESCRIPTION OF DRAWINGS

Features will become apparent to those of skill in the art by describing in detail example embodiments with reference to the attached drawings in which:
FIG. 1 shows a plan view of a semiconductor device according to an example embodiment of the present disclosure;
FIGS. 2A and 2B show cross-sectional views of a semiconductor device according to an example embodiment of the present disclosure;
FIGS. 3A to 3B show enlarged views of portions of a semiconductor device according to an example embodiment of the present disclosure;
FIGS. 4A and 4B show a cross-sectional view of a semiconductor device and an enlarged view of a portion of a semiconductor device according to an example embodiment of the present disclosure;
FIGS. 5A and 5B show enlarged views of a portion of a semiconductor device according to an example embodiment of the present disclosure;
FIG. 6 shows a cross-sectional view of a semiconductor device according to an example embodiment of the present disclosure;
FIG. 7 shows a cross-sectional view of a semiconductor device according to an example embodiment of the present disclosure;
FIGS. 8A and 8B show cross-sectional views of a semiconductor device according to an example embodiment of the present disclosure;
FIGS. 9A and 9B show cross-sectional views of a semiconductor device according to an example embodiment of the present disclosure;
FIGS. 10A to 10K and 11A to 11D show cross-sectional views of stages in a method of manufacturing a semiconductor device according to an example embodiment of the present disclosure;
FIG. 12 shows a view of a data storage system including a semiconductor device according to an example embodiment of the present disclosure;
FIG. 13 shows a perspective view of a data storage system including a semiconductor device according to an example embodiment of the present disclosure; and
FIG. 14 shows a cross-sectional view of a semiconductor package according to an example embodiment of the present disclosure.

### DETAILED DESCRIPTION

Example embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will fully convey the scope of the invention to those skilled in the art. Like reference numerals refer to like elements, and their repetitive descriptions are omitted.

It is to be understood that a singular form of a noun corresponding to an item may include one or more of the things, unless the relevant context clearly indicates otherwise. As used herein, each of such phrases as "A or B", "at least one of A and B", "at least one of A or B", "A, B, or C", "at least one of A, B, and C", and "at least one of A, B, or C", may include any one of possible combinations of the items enumerated together in a corresponding one of the phrases. It is to be understood that if an element (e.g., a first element) is referred to, with or without the term "operatively" or "communicatively", as "coupled with", "coupled to", "connected with", or "connected to" another element (e.g., a second element), it means that the element may be coupled with the other element directly or via a third element.

It is to be understood that when an element or layer is referred to as being "over", "above", "on", "below", "under", "beneath", "connected to" or "coupled to" another element or layer, it can be directly over, above, on, below, under, beneath, connected or coupled to the other element or layer or intervening elements or layers may be present. In contrast, when an element is referred to as being "directly over", "directly above", "directly on", "directly below", "directly under", "directly beneath", "directly connected to" or "directly coupled to" another element or layer, there are no intervening elements or layers present.

The terms "upper", "middle", "lower" may refer to relative positions along a particular direction (e.g. a vertical direction). Various directions (e.g. vertical direction, horizontal direction, etc.) may be defined relative to the structure of the devices described herein. It will be appreciated that these directions do not necessarily imply any particular orientation of the device in use. For instance, a vertical direction may be a direction perpendicular to an upper surface of a plate layer. Features or components that are "above" other features or components may be further along the vertical direction (further away from the plate layer) than the other features and components. The terms "upper", "middle", "lower", etc. may be replaced with terms, such as "first", "second", third" to be used to describe relative positions of elements. The terms "first", "second", third" may be used to describe various elements but the elements are not limited by the terms and a "first element" may be referred to as a "second element". Alternatively or additionally, the terms "first", "second", "third", etc. may be used to distinguish components from each other and do not limit the present disclosure. For example, the terms "first", "second", "third", etc. may not necessarily involve an order or a numerical meaning of any form.

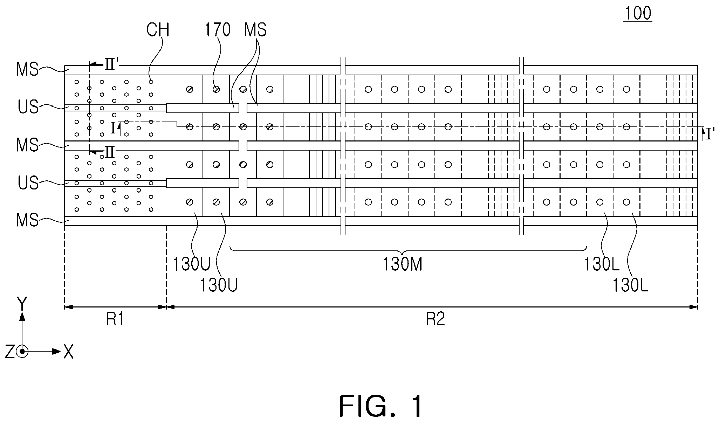

FIG. 1 shows a plan view of a semiconductor device according to an example embodiment.

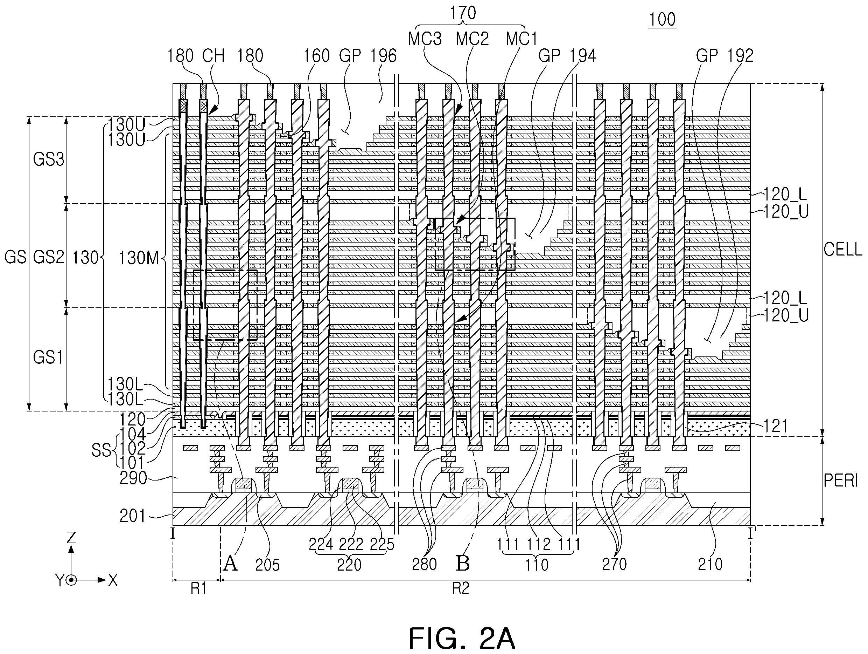

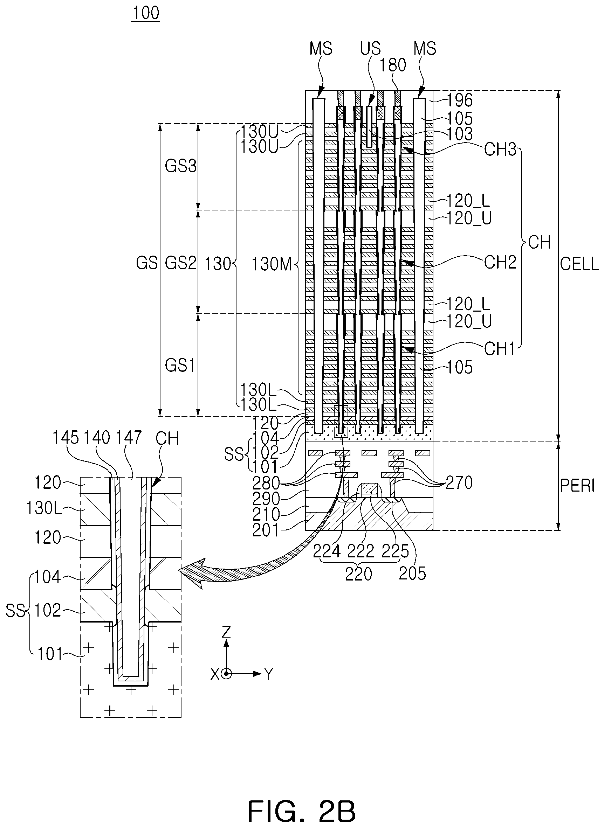

FIGS. 2A and 2B show cross-sectional views of a semiconductor device according to an example embodiment, taken along lines I-I' and II-II'.

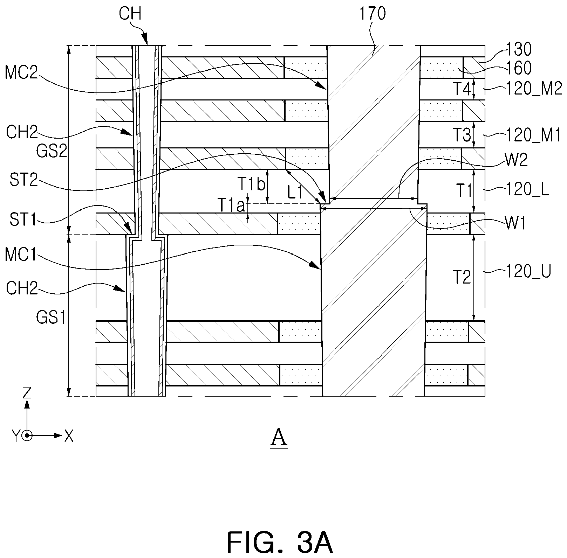

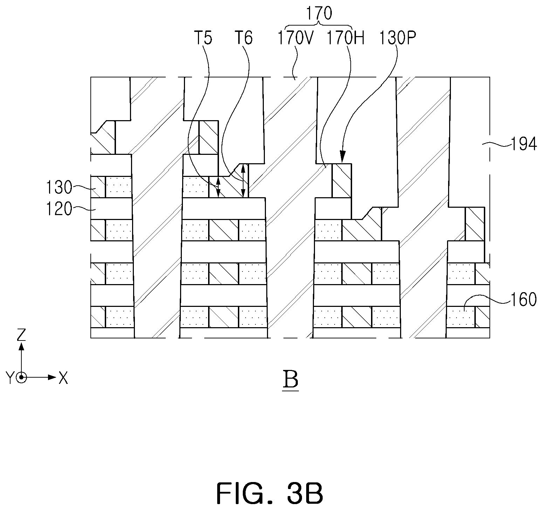

FIGS. 3A to 3B show enlarged views of portions of a semiconductor device according to an example embodiment. FIG. 3A shows "A" in FIG. 2A, and FIG. 3B shows region "B" in FIG. 2A.

Referring to FIGS. 1 to 3B, a semiconductor device 100 may include a peripheral circuit region PERI, which is a first semiconductor structure including a substrate 201, and a memory cell region CELL, which is a second semiconductor structure including a plate layer 101. The memory cell region CELL may be on the peripheral circuit region PERI. In example embodiments, alternatively, the memory cell region CELL may be below the peripheral circuit region PERI. Horizontal directions (e.g. an X-direction and a Y-direction) may be defined parallel to an upper surface of the plate layer 101. The X-direction and Y-direction may intersect (e.g. may be perpendicular to each other). A vertical direction (e.g. a Z-direction) may be defined perpendicular to the upper surface of the plate layer 101. The vertical direction may be perpendicular to the horizontal directions.

The peripheral circuit region PERI may include a substrate 201, impurity regions 205 and device isolation layers 210 in the substrate 201, circuit devices 220 on the substrate 201, peripheral region insulating layer 290, circuit contact plugs 270, and circuit interconnection lines 280.

The substrate 201 may have an upper surface extending in the X-direction and the Y-direction. In the substrate 201, an active region may be defined by the device isolation layers 210. Impurity regions 205 including impurities may be in a portion of the active region. The substrate 201 may include a semiconductor material, e.g., a group IV semiconductor, a group III-V compound semiconductor, or a group II-VI compound semiconductor. The substrate 201 may be provided as a bulk wafer or an epitaxial layer.

The circuit devices 220 may include planar transistors. Each of the circuit devices 220 may include a circuit gate dielectric layer 222, a spacer layer 224 and a circuit gate electrode 225. The impurity regions 205 may be disposed as source/drain regions in the substrate 201 on both sides of the circuit gate electrode 225.

The peripheral region insulating layer 290 may be on the circuit device 220 on the substrate 201. The peripheral region insulating layer 290 may include a plurality of insulating layers formed in different processes. The peripheral region insulating layer 290 may be formed of an insulating material.

The circuit contact plugs 270 and circuit interconnection lines 280 may form a circuit interconnection structure electrically connected to the circuit devices 220 and the impurity regions 205. The circuit contact plugs 270 may have a cylindrical shape, and the circuit interconnection lines 280 may have a line shape (e.g. a linear shape). An electrical signal may be applied to the circuit device 220 by the circuit contact plugs 270 and the circuit interconnection lines 280. The circuit contact plugs 270 may also be connected to the circuit gate electrode 225. The circuit interconnection lines 280 may be connected to the circuit contact plugs 270, may have a line shape, and may be in a plurality of layers. The circuit contact plugs 270 and the circuit interconnection lines 280 may include a conductive material, e.g., tungsten (W), copper (Cu), aluminum (Al), and the like, and each component may further include a diffusion barrier. In example embodiments, the number of layers of the circuit contact plugs 270 and the circuit interconnection lines 280 may be varied.

The memory cell region CELL may have first and second regions R1 and R2. The memory cell region CELL may include a source structure SS including a plate layer 101, gate electrodes 130 stacked on the source structure SS and forming gate structure GS, interlayer insulating layers 120 alternately stacked with the gate electrodes 130 and forming the gate structure GS, channel structures CH penetrating through the gate structure GS in the first region R1, first isolation regions MS extending by penetrating through the gate structure GS, second isolation regions US penetrating through a portion of the gate electrodes 130 on an upper portion, and contact plugs 170 connected to the gate electrodes 130 and extending vertically in the second region R2. The memory cell region CELL may include a horizontal insulating layer 110 below the gate electrodes 130 in the second region R2, substrate insulating layers 121 disposed to penetrate through the plate layer 101, studs 180 on the channel structures CH and the contact plugs 170, and first to third cell region insulating layers 192, 194, and 196 covering the gate electrodes 130.

In the memory cell region CELL, in the first region R1, the gate electrodes 130 may be vertically stacked and the channel structures CH may be disposed, and memory cells may be in the first region R1. In the second region R2, the gate electrodes 130 may extend by different lengths and may form gate pad regions GP, and the second region R2 may be configured to electrically connect the memory cells to the peripheral circuit region PERI. The second region R2 may be on at least one end of the first region R1 in at least one direction, e.g., the X-direction.

The source structure SS may include a plate layer 101, a first horizontal conductive layer 102, and a second horizontal conductive layer 104 stacked in order in the first region R1. However, in example embodiments, the number of conductive layers included in the source structure SS may be varied.

The plate layer 101 may have a plate shape and may function as at least a portion of a common source line of the semiconductor device 100. The plate layer 101 may have an upper surface extending in the X-direction and the Y-direction. The plate layer 101 may include a conductive material. In an implementation, the plate layer 101 may include a semiconductor material, e.g., a group IV semiconductor, a group III-V compound semiconductor, or a group II-VI compound semiconductor. In an implementation, a group IV semiconductor may include silicon, germanium, or silicon-germanium. The plate layer 101 may further include impurities. The plate layer 101 may be a polycrystalline semiconductor layer such as a polycrystalline silicon layer or an epitaxial layer.

The first and second horizontal conductive layers 102 and 104 may be stacked in order on the upper surface of the plate layer 101 in the first region R1. The first horizontal conductive layer 102 may not extend into the second region R2, and the second horizontal conductive layer 104 may extend into the second region R2. The first horizontal conductive layer 102 may function as a portion of a common source line of the semiconductor device 100, and may function as a common source line together with the plate layer 101. As shown in the enlarged view in FIG. 2B, the first horizontal conductive layer 102 may be directly connected to the channel layer 140 around the channel layer 140. The second horizontal conductive layer 104 may be in contact with the plate layer 101 in partial regions of the second region R2 in which the first horizontal conductive layer 102 and the horizontal insulating layer 110 are not disposed.

The first and second horizontal conductive layers 102 and 104 may include a semiconductor material, such as polycrystalline silicon. In this case, at least the first horizontal conductive layer 102 may be doped with impurities of the same conductivity-type as that of the plate layer 101, and the second horizontal conductive layer 104 may be configured as a doped layer or may include impurities diffused from the first horizontal conductive layer 102. However, the material of the second horizontal conductive layer 104 may be replaced with an insulating layer.

The horizontal insulating layer 110 may be on the plate layer 101 on the same level as a level of the first horizontal conductive layer 102 in at least a portion of the second region R2. The horizontal insulating layer 110 may include first and second horizontal insulating layers 111 and 112 alternately stacked on the second region R2 of the plate layer 101. The horizontal insulating layer 110 may be layers remaining after a portion thereof is replaced with the first horizontal conductive layer 102 in the process of manufacturing the semiconductor device 100.

The horizontal insulating layer 110 may include silicon oxide, silicon nitride, silicon carbide, or silicon oxynitride. The first horizontal insulating layer 111 and the second horizontal insulating layer 112 may include different insulating materials. In an implementation, the first horizontal insulating layer 111 may be formed of the same material as that of the interlayer insulating layers 120, and the second horizontal insulating layer 112 may be formed of a material different from that of the interlayer insulating layers 120.

The substrate insulating layers 121 may penetrate through the plate layer 101, the horizontal insulating layer 110, and the second horizontal conductive layer 104 in a portion of the second region R2. The substrate insulating layers 121 may be in the first region R1, and may be in a region in which through-vias extending from the memory cell region CELL to the peripheral circuit region PERI are. An upper surface of the substrate insulating layer 121 may be coplanar with an upper surface of the second horizontal conductive layer 104. The substrate insulating layer 121 may include an insulating material such as silicon oxide, silicon nitride, silicon carbide, or silicon oxynitride.

The gate electrodes 130 may be vertically stacked and spaced apart from each other on the plate layer 101 and may form a gate structure GS together with the interlayer insulating layers 120. The gate structure GS may include first to third stack structures GS1, GS2, and GS3 which may be vertically stacked. However, in example embodiments, the number of stack structures included in the gate structure GS may be varied. In some example embodiments, the gate structure GS may include four or more stack structures or may include a single stack structure. The number of gate electrodes 130 included in each of the first to third stack structures GS1, GS2, and GS3 may be the same or different. In at least second and third stack structures GS2 and GS3 among the first to third stack structures GS1, GS2, and GS3, the gate electrode 130 may be in a lowermost portion. An interlayer insulating layer 120 may be in an uppermost portion of at least first and second stack structures GS1 and GS2 among the first to third stack structures GS1, GS2, and GS3.

The gate electrodes 130 may include lower gate electrodes 130L forming the gate of a ground select transistor, memory gate electrodes 130M forming a plurality of memory cells, and upper gate electrodes 130U forming gates of string select transistors. The number of the memory gate electrodes 130M forming memory cells may be determined depending on capacity of the semiconductor device 100. In example embodiments, the upper and lower gate electrodes 130U and 130L may be 1 to 4 or more, respectively, and may have a structure the same as or different from that of the memory gate electrodes 130M. In example embodiments, the gate electrodes 130 may further include a gate electrode 130 disposed adjacently to the upper gate electrodes 130U and/or the lower gate electrodes 130L and forming an erase transistor used for an erase operation using a gate induced drain leakage (GIDL) phenomenon. Also, memory gate electrodes 130M adjacent to a portion of the gate electrodes 130, e.g., upper or lower gate electrodes 130U and 130L, may be dummy gate electrodes.

As shown in FIG. 1, the gate electrodes 130 may be isolated from each other in the Y-direction by the first isolation regions MS continuously extending in the first region R1 and the second region R2. Gate electrodes 130 between a pair of first isolation regions MS may form a memory block. A portion of the gate electrodes 130, e.g., the memory gate electrodes 130M may form a layer in a memory block.

The gate electrodes 130 may be vertically stacked and spaced apart from each other on the first region R1, may extend by different lengths from the first region R1 to the second region R2 and may form step structures of a staircase form in the gate pad regions GP. As shown in FIG. 2A, the gate electrodes 130 may have a shape removed to a predetermined depth from an upper portion of one of the first to third stack structures GS1, GS2, and GS3 in the gate pad regions GP. The gate pad regions GP may not overlap each other in the Z-direction. On the gate pad regions GP of the lower first and the second stack structures GS1 and GS2, the gate electrodes 130 forming the upper second and third stack structures GS2 and GS3 may extend horizontally. In the example embodiment, the gate pad regions GP may be in order in the third stack structure GS3, the second stack structure GS2, and the first stack structure GS1 in the X-direction from the first region R1. Only one gate pad region GP may be shown in each of the first to third stack structures GS1, GS2, and GS3, but a plurality of gate pad regions GP may be in each of the first to third stack structures GS1, GS2, and GS3. However, in example embodiments, the arrangement shape, the arrangement order, and the depth of the gate pad regions GP may be varied. In some example embodiments, the gate electrodes 130 may not be on the gate pad regions GP.

The gate electrodes 130 may form first and second step structures in an asymmetrical form in the X-direction in each gate pad region GP. The first step structure may be configured to be relatively adjacent to the first region R1 and to have a level decreasing in the X-direction, and the second step structure may be configured to be relatively spaced apart from the first region R1 and to have a level increasing in the X-direction. The second step structure may be further from the first region R1 than the first step structure. In an implementation, in each gate pad region GP, a slope of the first step structure may be smaller than a slope of the second step structure in the first region R1. However, in some example embodiments, the first and second step structures may have symmetrical shapes. In the first step structure, the gate electrodes 130 may be connected to the contact plugs 170, and in the second step structure, the gate electrodes 130 may form a dummy region or a dummy structure not connected to the contact plugs 170. In some example embodiments, the gate electrodes 130 may have a step structure even in the Y-direction.

As shown in FIG. 3B, by the first step structure, a lower gate electrode 130 may extend longer than an upper gate electrode 130, and may have contact regions 130P exposed upwardly from the interlayer insulating layers 120, respectively. The gate electrodes 130 may be connected to the contact plugs 170 in the contact regions 130P, respectively, which may be end regions. The gate electrodes 130 may have an increased thickness in the contact regions 130P. The gate electrodes 130 may have a thickness T6 greater in the contact region 130P than a thickness T5 in a region including the first region R1 in which other gate electrodes 130 are on their upper surface.

The gate electrodes 130 may include a metal material, such as tungsten (W). In example embodiments, the gate electrodes 130 may include polycrystalline silicon or a metal silicide material. In example embodiments, the gate electrodes 130 may further include a diffusion barrier, and, e.g., the diffusion barrier may include tungsten nitride (WN), tantalum nitride (TaN), titanium nitride (TiN), or a combination thereof.

The interlayer insulating layers 120 may be between the gate electrodes 130. An interlayer insulating layer 120 may be between each adjacent pair of gate electrodes 130. Similarly to the gate electrodes 130, the interlayer insulating layers 120 may be spaced apart from each other in a direction perpendicular to the upper surface of the plate layer 101 (e.g. the Z-direction) and may extend in the X-direction. The interlayer insulating layers 120 may include an insulating material such as silicon oxide or silicon nitride. In each of the first to third stack structures GS1, GS2, and GS3, at least a portion of the interlayer insulating layers 120 may have different thicknesses.

FIG. 3A shows an enlarged view of a region including interfacial surface between the first stack structure GS1 and the second stack structure GS2. As shown in FIG. 3A, the lowermost interlayer insulating layer 120_L of the second stack structure GS2 may have a first thickness T1, and the uppermost interlayer insulating layer 120_U of the first stack structure GS1 adjacently below may have a second thickness T2 greater than the first thickness T1. The interlayer insulating layer 120_M1 adjacently above the lowermost interlayer insulating layer 120_L may have a third thickness T3 smaller than the first thickness T1. The interlayer insulating layer 120_M2 between the gate electrodes 130 of the intermediate region of the second stack structure GS2 may have a fourth thickness T4, which may be smaller than the first to third thicknesses T1, T2, and T3. One or more further interlayer insulating layers 120 having the fourth thickness T4 may be provided above the interlayer insulating layer 120_M2. Among the interlayer insulating layers 120, the number of interlayer insulating layers 120 having the fourth thickness T4 may be the highest. In an implementation, in at least an intermediate region of each of the first to third stack structures GS1, GS2, and GS3, the interlayer insulating layers 120 may have the fourth thickness T4.

The first thickness T1 may range from about 1.5 times to about 2.7 times, e.g., from 1.5 to 2.7 times) the fourth thickness T4. For instance, the first thickness may range from about 1.8 times to about 2.3 times (e.g. 1.8 times to 2.3 times) the fourth thickness T4. In an implementation, the first thickness T1 may range from about 32 nm to about 42 nm (e.g. 32nm to 42nm). The second thickness T2 may range from about 5 times to about 7 times (e.g. 5 times to 7 times) the fourth thickness T4. The third thickness T3 may range from about 1.1 times to about 1.5 times (e.g. 1.1 times to 1.5 times) the fourth thickness T4. In example embodiments, the number of the interlayer insulating layers 120 having the third thickness T3 may be varied depending on the number of gate electrodes 130 included in the first to third stack structures GS1, GS2, and GS3. In the present application, any values that are specified as being "about" a certain value, may be substantially, approximately, or exactly that value.

The description of the thickness relationship of the interlayer insulating layers 120 may be equally applied to a region including an interfacial surface between the second stack structure GS2 and the third stack structure GS3.

The channel structures CH may form one memory cell string, and may be spaced apart from each other while forming rows and columns on the plate layer 101 in the first region R1. The channel structures CH may form a lattice pattern in the x-y plane or a zigzag pattern in one direction. The channel structures CH may have a column shape and may have a sloped side surface having a width decreasing toward the plate layer 101 depending on an aspect ratio. In example embodiments, at least a portion of the channel structures CH on an end of the first region R1 may be dummy channel structures.

As shown in FIG. 2B, each of the channel structures CH may include the first to third channel portions CH1, CH2, and CH3 vertically stacked. The first to third channel portions CH1, CH2, and CH3 may penetrate through the first to third stack structures GS1, GS2, and GS3 of the gate structure GS, respectively. The channel structure CH may have a form in which a first channel portion CH1 and an upper second channel portion CH2 are connected to each other, and a second channel portion CH2 and a third channel portion CH3 are connected to each other. The first to third channel portions CH1, CH2, and CH3 may have a shape in which a width of an upper surface of a channel portion below may be greater than a width of a lower surface of a channel portion above in a connected region or an interfacial surface. The channel structure CH may have bent portions due to a difference in widths on the interfacial surface between the first to third channel portions CH1, CH2, and CH3. However, in example embodiments, the number of channel portions stacked in the Z-direction in the channel structure CH may be varied. The first channel portion CH1 may further penetrate through the source structure SS, and a lower end of the first channel portion CH1 may be in the plate layer 101.

Each of the channel structures CH may include a channel layer 140, a gate dielectric layer 145, a channel buried insulating layer 147, and a channel pad 149 in a channel hole. The channel layer 140, the gate dielectric layer 145, and the channel buried insulating layer 147 may be connected to each other between the first to third channel portions CH1, CH2, and CH3.

As shown in the enlarged view in FIG. 2B, the channel layer 140 may be formed in an annular shape surrounding the internal channel buried insulating layer 147. In example embodiments, the channel layer 140 may have a column shape such as a cylindrical shape or a prismatic shape without the channel buried insulating layer 147. The channel layer 140 may be connected to the first horizontal conductive layer 102 in a lower portion. The channel layer 140 may include a semiconductor material such as polycrystalline silicon or single crystalline silicon.

The gate dielectric layer 145 may be between the gate electrodes 130 and the channel layer 140. The gate dielectric layer 145 may include a tunneling layer, a charge storage layer, and a blocking layer stacked in order from the channel layer 140. The tunneling layer may tunnel electric charges into the charge storage layer, and may include, e.g., silicon oxide (SiO₂), silicon nitride (Si₃N₄), silicon oxynitride (SiON), or a combination thereof. The charge storage layer may be configured as a charge trap layer or a floating gate conductive layer. The blocking layer may include silicon oxide (SiO₂), silicon nitride (Si₃N₄), silicon oxynitride (SiON), a high-k dielectric material, or a combination thereof. In example embodiments, at least a portion of the gate dielectric layer 145 may extend in a horizontal direction along the gate electrodes 130.

The channel pad 149 may be only on an upper end of the upper third channel portion CH3. The channel pad 149 may include, e.g., doped polycrystalline silicon.

The first isolation regions MS may penetrate through at least a portion of the gate electrodes 130 and may extend in the X-direction. As shown in FIG. 1, the first isolation regions MS may be parallel to each other. A portion of the isolation regions MS may extend to one along the first region R1 and the second region R2, and another portion may extend only to a portion of second region R2, or may be intermittently disposed in the first region R1 and the second region R2.

The first isolation regions MS may be connected to the plate layer 101 by penetrating through the gate electrodes 130 stacked on the plate layer 101 and further penetrating through the first and second horizontal conductive layers 102 and 104 below. The first isolation regions MS may have a shape in which a width may decrease toward the plate layer 101 due to a high aspect ratio. In an implementation, a side surface of the first isolation regions MS may have a side surface of a substantially constant slope such that a width may continuously or continuously decrease, and may not have a bent portion on a side surface.

A gate isolation insulating layer 105 may be in each of the first isolation regions MS. The gate isolation insulating layer 105 may include an insulating material, e.g., silicon oxide, silicon nitride, or silicon oxynitride.

As shown in FIG. 1, the second isolation regions US may extend in the X-direction between first isolation regions MS adjacent to each other. The second isolation regions US may be in a portion of the second region R2 and the first region R1. The second isolation regions US may penetrate through a portion of the gate electrodes 130 including the uppermost upper gate electrode 130U among the gate electrodes 130. The second isolation regions US may isolate, e.g., three gate electrodes 130 from each other in the Y-direction, as shown in FIG. 2B. However, the number of gate electrodes 130 isolated by the second isolation regions US may be varied in example embodiments.

Each of the second isolation regions US may include an upper isolation insulating layer 103. The upper isolation insulating layer 103 may include an insulating material, e.g., silicon oxide, silicon nitride, or silicon oxynitride.

The contact plugs 170 may be connected to the contact regions 130P of the gate electrodes 130 in the gate pad regions GP of the second region R2. The contact plugs 170 may penetrate through at least a portion of the cell region insulating layer 190 and may be connected to each of the contact regions 130P of the gate electrodes 130 exposed upwardly. The contact plugs 170 may penetrate through the gate electrodes 130 above and below the contact regions 130P, may penetrate through the second horizontal conductive layer 104, the horizontal insulating layer 110, and the plate layer 101, and may be connected to the circuit interconnection lines 280 in the peripheral circuit region PERI. The contact plugs 170 may be spaced apart from the gate electrodes 130 above and below the contact regions 130P by the contact insulating layers 160. The contact plugs 170 may be spaced apart from the plate layer 101, the horizontal insulating layer 110, and the second horizontal conductive layer 104 by the substrate insulating layers 121. In some example embodiments, a portion of the contact plugs 170 may be in a region other than the gate pad regions GP, e.g., the first region R1. In some example embodiments, the contact plugs 170 may be connected to each of the contact regions 130P of the gate electrodes 130 exposed upwardly without penetrating through the gate electrodes 130.

The contact plugs 170 may have a shape corresponding to that of the channel structures CH. Each of the contact plugs 170 may include first to third contact portions MC1, MC2, and MC3 stacked from a lower portion. The first to third contact portions MC1, MC2, and MC3 may penetrate through the first to third stack structures GS1, GS2, and GS3 of the gate structure GS, respectively. The first contact portion MC1 may further penetrate through the substrate insulating layer 121. The first to third contact portions MC1, MC2, and MC3 may have a cylindrical shape having a width decreasing toward the substrate 201 due to an aspect ratio. Each of first to third contact portions MC1, MC2, and MC3 may have a substantially constant slope. The first contact portion MC1 may further include a landing region having a width expanding below the substrate insulating layer 121. However, in some example embodiments, the first contact portion MC1 may not include the landing region.

The first to third contact portions MC1, MC2, and MC3 may have a shape in which a width of an upper surface of the contact portion below may be greater than a width of a lower surface of the contact portion above in a connected region or an interfacial surface. Accordingly, similarly to the channel structure CH, the contact plug 170 may also have bent portions due to a difference in width on the interfacial surface between the first to third contact portions MC1, MC2, and MC3. In the bent portions, the width may be rapidly changed, and a region in which the side surface extends horizontally may be included.

As shown in FIG. 3A, a first width W1 of an upper end of the first contact portion MC1 may be greater than a second width W2 of a lower end of the second contact portion MC2. Accordingly, the contact plug 170 may have a second bent portion ST2 on an interfacial surface between the first contact portion MC1 and the second contact portion MC2. For each of the first to third contact portions MC1, MC2 and MC3, the width of the lower end may be less than width of the corresponding upper end. In the example embodiment, in a contact plug 170, diameters of upper ends of first to third contact portions MC1, MC2, and MC3 may be substantially equal to each other, and diameters of lower ends may also be substantially equal to each other.

A level of the interfacial surface between the first contact portion MC1 and the second contact portion MC2 may be different from a level of the interfacial surface between the first channel portion CH1 and the second channel portion CH2. A level of an upper surface of the first contact portion MC1 may be different from a level of an upper surface of the first channel portion CH1, and a level of an upper surface of the second contact portion MC2 may be different from a level of an upper surface of the second channel portion CH2.

As shown in FIG. 3A, in the channel structure CH, a first interfacial surface between the first channel portion CH1 and the second channel portion CH2 may be on an interfacial surface between the first stack structure GS1 and the second stack structure GS2. A first bent portion ST1 may be formed along the first interfacial surface. In the contact plug 170, a second interfacial surface between the first contact portion MC1 and the second contact portion MC2 may be on a level higher than a level of the interfacial surface between the first stack structure GS 1 and the second stack structure GS2. A second bent portion ST2 may be formed along the second interfacial surface.

The second interfacial surface may be on a level higher than a level of the first interfacial surface. The first interfacial surface may be on a lower surface of the lowermost gate electrode 130 included in the second stack structure GS2, which is a lowermost layer forming the second stack structure GS2, that is, on the same level as a level of the lower surface. The second interfacial surface may be on a level higher than the level of the lower surface of the lowermost gate electrode 130 included in the second stack structure GS2. The second interfacial surface may be on a level higher than a level of an upper surface of the lowermost gate electrode 130 included in the second stack structure GS2 and may be in the lowermost interlayer insulating layer 120_L included in the second stack structure GS2. A thickness T1a by which the first contact portion MC1 protrudes into the lowermost interlayer insulating layer 120_L may be smaller than a non-penetrated thickness T1b. That is, the second bent portion ST2 may be closer to the lower surface of the lowermost interlayer insulating layer 120_L than the upper surface of the lowermost interlayer insulating layer 120_L. In some example embodiments, the protruding thickness T1a may be greater than the non-penetrated thickness T1b. In these embodiments, the second bent portion ST2 is be closer to the upper surface of the lowermost interlayer insulating layer 120_L than the lower surface of the lowermost interlayer insulating layer 120_L. In some example embodiments, the protruding thickness T1a may be relatively small, and the second interfacial surface may be on a level of the upper surface of the lowermost gate electrode 130 or on a level adjacent to the upper surface.

The description of the dispositional relationship between the first interfacial surface and the second interfacial surface may also be applied to second contact portion MC2 and the third contact portion MC3. In the example embodiment, since the lowermost interlayer insulating layer 120_L has a relatively large thickness, a spacing distance L1 between the upper surface of the first contact portion MC1 and the upper gate electrode 130 may be secured. Accordingly, defects, such as electrical short or leakage current between the contact plug 170 and the gate electrode 130 not connected thereto may be prevented.

As shown in FIG. 3B, the contact plug 170 may have a horizontally extended form in the contact region 130P. The contact plug 170 may include a vertical extension portion 170V extending in the Z-direction and a horizontal extension portion 170H extending horizontally from the vertical extension portion 170V and in contact with the gate electrode 130. The horizontal extension portion 170H may be along a circumference of the vertical extension portion 170V, and the entire side surface may be surrounded by the gate electrode 130. A length from a side surface of the vertical extension portion 170V to an end of the horizontal extension portion 170H may be smaller than a length from a side surface of the vertical extension portion 170V to external side surfaces of the contact insulating layers 160. The contact plug 170 may be electrically isolated from the gate electrodes 130 above and below the contact regions 130P, that is, gate electrodes 130 not connected to the contact plug 170, by the contact insulating layers 160.

The contact plugs 170 may include a conductive material, e.g., tungsten (W), copper (Cu), aluminum (Al), or an alloy thereof. In some example embodiments, the contact plugs 170 may include a barrier layer extending along a side surface and a bottom surface, or may have an air gap therein.

The contact insulating layers 160 may surround the side surface of each of the contact plugs 170 above and below the contact regions 130P. The contact insulating layers 160 may be spaced apart from each other in the Z-direction around each of the contact plugs 170. The contact insulating layers 160 may horizontally extend by substantially the same length from the side surface of each of the contact plugs 170. The contact insulating layers 160 may be on substantially the same level as a level of the gate electrodes 130. The contact insulating layers 160 may include an insulating material, e.g., silicon oxide, silicon nitride, or silicon oxynitride.

The studs 180 may form a cell interconnection structure electrically connected to memory cells in the memory cell region CELL. The studs 180 may be connected to the channel structures CH and the contact plugs 170, and may be electrically connected to the channel structures CH and the gate electrodes 130. The studs 180 may have a plug shape, and the studs 180 may have a line shape. In example embodiments, the number of plugs and interconnection lines included in the cell interconnection structure may be varied. The studs 180 may include metal, e.g., tungsten (W), copper (Cu), or aluminum (Al).

The first to third cell region insulating layers 192, 194, and 196 may cover first to third stack structures GS1, GS2, and GS3, respectively. The first to third cell region insulating layers 192, 194, and 196 may be formed of an insulating material or may include a plurality of insulating layers. When the first to third cell region insulating layers 192, 194, and 196 include the same material as that of the interlayer insulating layers 120, interfacial surfaces with the interlayer insulating layers 120 may not be distinct.

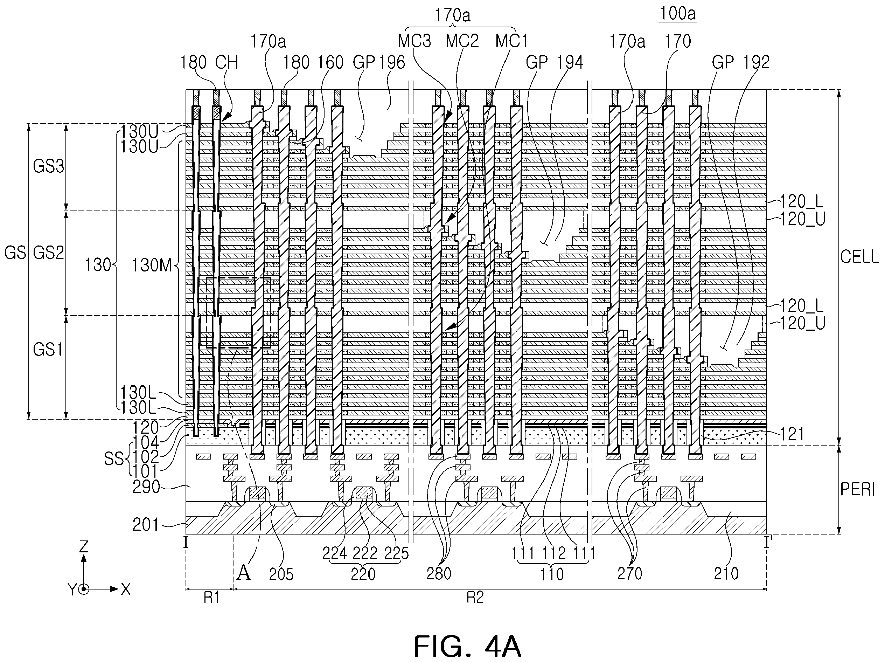

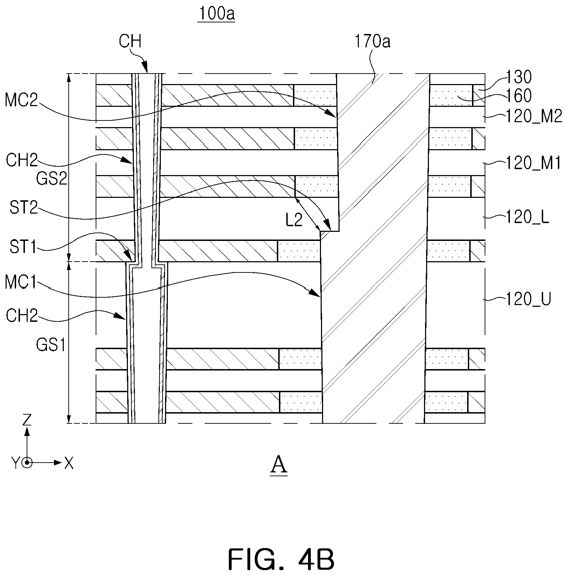

FIGS. 4A and 4B show a cross-sectional view of a semiconductor device and an enlarged view showing a portion of a semiconductor device according to an example embodiment, showing regions corresponding to FIGS. 2A and 3A, respectively.

Referring to FIGS. 4A and 4B, in a semiconductor device 100a, contact plugs 170a, a portion of contact plugs 170 and 170a, may have a form in which at least a portion of first to third contact portions MC1, MC2, and MC3 may be misaligned with each other.

As shown in FIG. 4B, in contact plugs 170a, when the first contact portion MC1 and the second contact portion MC2 are misaligned, a central axis of the first contact portion MC1 and a central axis of the second contact portion MC2 may be shifted from each other in a horizontal direction. In this case, a length of the region extending in the horizontal direction in the second bent portion ST2 may be relatively large. A spacing distance L2 between an upper end corner of the first contact portion MC1 and the upper gate electrode 130 may be relatively reduced. Even in this case, since the lowermost interlayer insulating layer 120_L has a relatively large thickness, the spacing distance L2 may be stably secured.

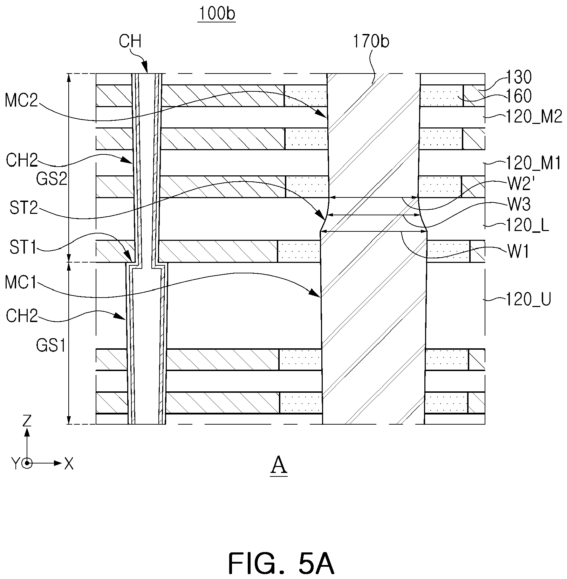

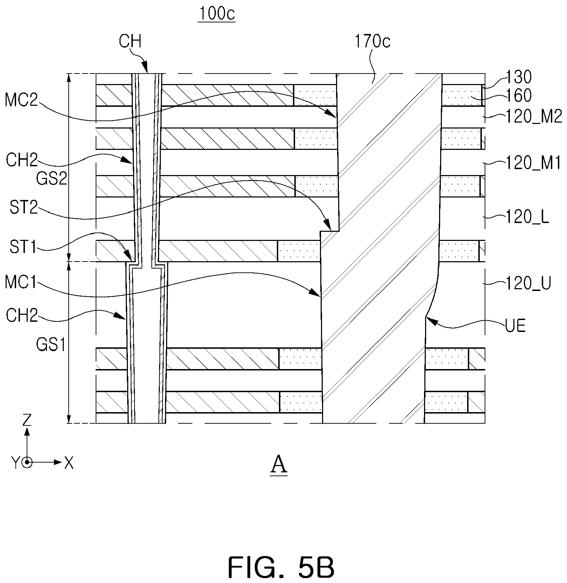

FIGS. 5A and 5B show enlarged views of a portion of a semiconductor device according to an example embodiment, showing a region corresponding to FIG. 3A.

Referring to FIG. 5A, in a semiconductor device 100b, at least second and third contact portions MC2 and MC3 of contact plug 170b may include regions in which a width thereof may increase in a lower region connected to the first and second contact portions MC1 and MC2 thereunder.

As shown in FIG. 5A, an upper end of the first contact portion MC1 may have a first width W1, and the second contact portion MC2 may have a second width W2', which is a minimum width in a region higher than the lower end. The second contact portion MC2 may include an upper region of which a width may decrease with a constant slope from an upper surface to a region having a second width W2', and may further include a lower region of which a width may increase from the region having the second width W2' to the first contact portion MC1. In the lower region, the second contact portion MC2 may have a third width W3 greater than the second width W2' and smaller than the first width W1. This shape may be formed due to etching conditions when the contact plug 170b is formed.

Referring to FIG. 5B, in the semiconductor device 100c, the contact plug 170c may have a shape in which the first contact portion MC1 and the second contact portion MC2 are misaligned, similarly to the example embodiment in FIGS. 4A and 4B, and may have a curvature on one side surface on the cross-sectional view.

A side surface region of the second contact portion MC2 shifted to an external side of the first contact portion MC1 may have a shape in which the first stack structure GS1 is partially recessed. Accordingly, the lowermost end UE of the second contact portion MC2 may be in the first stack structure GS1. In FIG. 5B, the lowermost end UE of the second contact portion MC2 may be in the uppermost interlayer insulating layer 120_U of the first stack structure GS1. In some example embodiments, the lowermost end UE may be on an upper surface of the uppermost contact insulating layer 160 of the first stack structure GS1.

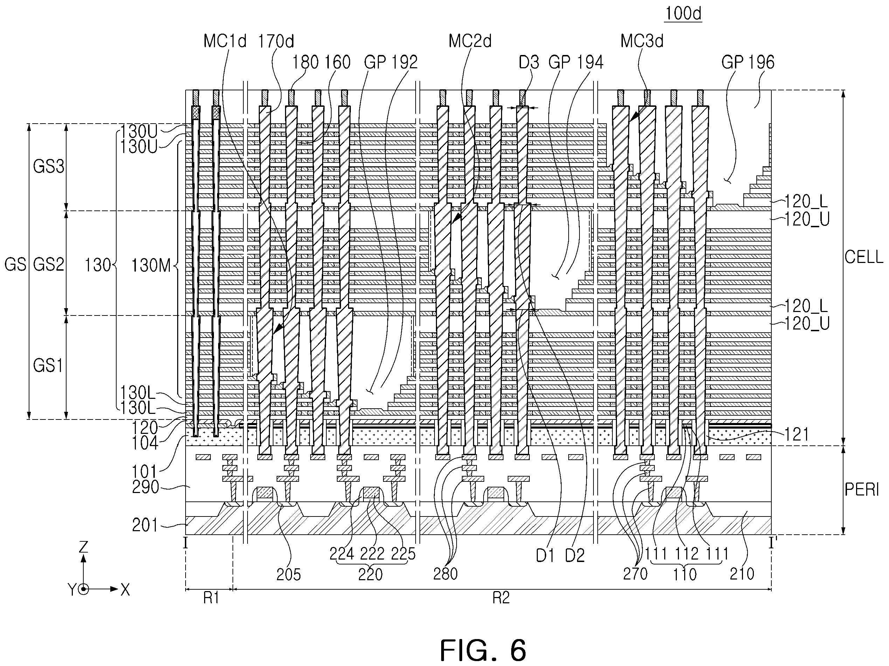

FIG. 6 shows a cross-sectional view of a semiconductor device according to an example embodiment, showing a region corresponding to FIG. 2A.

Referring to FIG. 6, in a semiconductor device 100d, the shape of the gate pad regions GP and the shape of the contact plugs 170d may be different from those in the example embodiment in FIG. 2A.

In the example embodiment, in the gate pad regions GP, regions exposing the gate electrodes 130 in a lower portion of each of the first to third stack structures GS1, GS2, and GS3 are selectively shown. The gate pad regions GP may be disposed in order in the first stack structure GS1, the second stack structure GS2, and the third stack structure GS3 in the X-direction from the first region R1. However, the arrangement order of the gate pad regions GP may be varied in example embodiments.

In the contact plugs 170d, one of the stacked first to third contact portions may have a relatively long length on which the contact portion penetrates through each of the first to third cell region insulating layers 192, 194, and 196. In an implementation, the contact portion may be the first contact portions MC1d connected to the gate electrodes 130 in the lower portion of the first stack structure GS1, the second contact portions MC2d connected to the gate electrodes 130 in the lower portion of the second stack structure GS2, and the third contact portions MC3d connected to the gate electrodes 130 in the lower portion of the third stack structure GS3. In each of the contact plugs 170d, the first to third contact portions MC1d, MC2d, and MC3d may have a relatively large diameter. In an implementation, in the contact plug 170d connected to the gate electrode 130 of the second stack structure GS2, the first contact portion may have a first diameter D1 on an upper end, the second contact portion MC2d may have a second diameter D2 greater than the first diameter D1 on an upper end, and the third contact portion may have a third diameter D3 smaller than the second diameter D2 on an upper end.

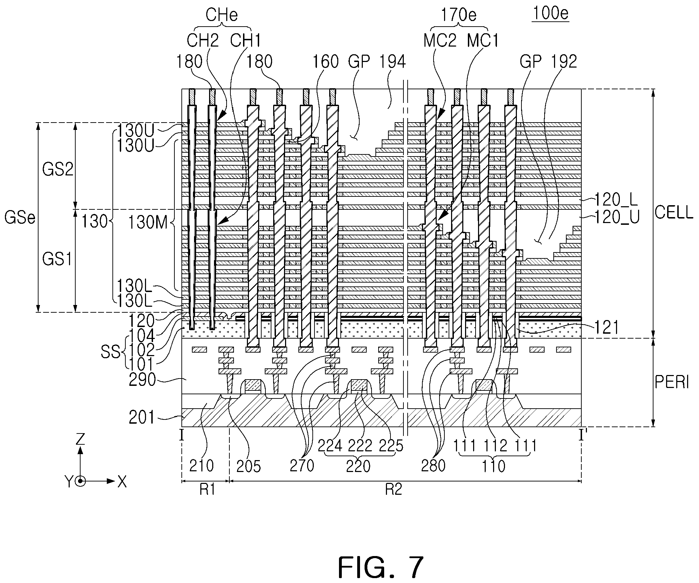

FIG. 7 shows a cross-sectional view of a semiconductor device according to an example embodiment, showing a region corresponding to FIG. 2A.

Referring to FIG. 7, in the semiconductor device 100e, the shapes of the gate structure GSe, the channel structures CHe, and the contact plugs 170e may be different from those in the example embodiment in FIG. 2A.

The gate structure GSe may include first and second stack structures GS1 and GS2 which may be vertically stacked. Each of the channel structures CHe may include first and second channel portions CH1 and CH2 penetrating through the first and second stack structures GS1 and GS2, respectively. Each of the contact plugs 170e may include first and second contact portions MC1 and MC2 stacked in the Z-direction. Each of the first and second contact portions MC1 and MC2 may penetrate through the first and second stack structures GS1 and GS2 of the gate structure GS. In the example embodiment, the interfacial surface between the first contact portion MC1 and the second contact portion MC2 may also be in the lowermost interlayer insulating layer 120_L of the second stack structure GS2.

As such, in example embodiments, the number of stack structures included in the gate structure GS may be varied, and accordingly, the number of stacked portions in the Z-direction in each of the channel structures CHe and contact plugs 170e may be varied.

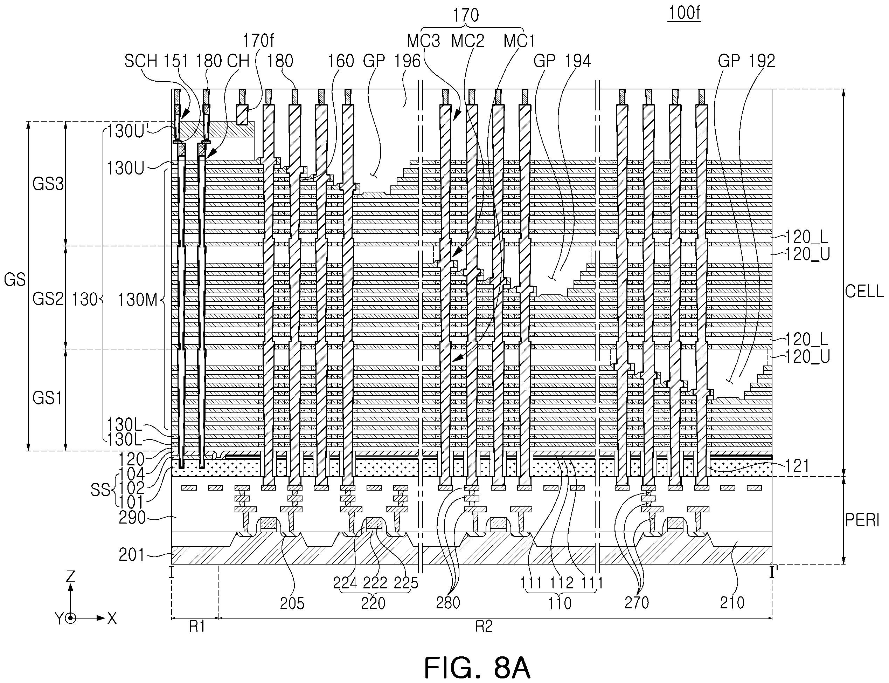

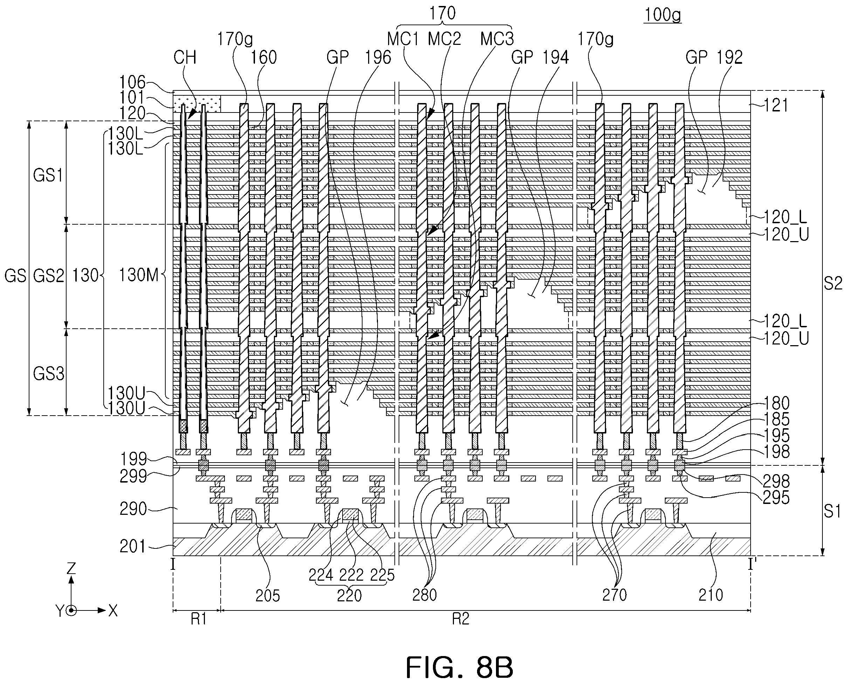

FIGS. 8A and 8B show cross-sectional views of a semiconductor device according to an example embodiment, showing a region corresponding to FIG. 2A.

Referring to FIG. 8A, in a semiconductor device 100f, the memory cell region CELL may further include string channel structures SCH connected to channel structures CH.

Among the gate electrodes 130, the uppermost gate electrode 130U' may have a relatively thick thickness. The string channel structures SCH may penetrate through the uppermost gate electrode 130U', and the channel structures CH may penetrate through the gate electrodes 130 other than the uppermost gate electrode 130U'.

The string channel structures SCH may be connected to the channel structures CH, respectively. The string channel structures SCH may be on the channel structures CH, respectively, and may be horizontally shifted from the channel structures CH. The internal structure of the string channel structures SCH may correspond to the channel structures CH, and accordingly, the stacked form of the layers may be the same or similar. The string channel structures SCH may include an upper channel layer, an upper gate dielectric layer, an upper channel buried insulating layer, and an upper channel pad in the string channel hole, and may further include a connection pad 151 below the string channel hole. The upper channel layer may be connected to a connection pad 151 in a lower portion, and may be electrically connected to a channel layer 140 (see FIG. 2B) of the channel structure CH through the connection pad 151.

As for the material of the upper channel layer, the upper gate dielectric layer, the upper channel buried insulating layer, and the upper channel pad, the description of each of the channel layer 140, the gate dielectric layer 145, the channel buried insulating layer 147, and the channel pad 149 described above with reference to FIG. 2B may be applied. The connection pad 151 may include a conductive material, e.g., polycrystalline silicon.

Among the contact plugs 170 and 170f, the contact plug 170f connected to the uppermost gate electrode 130U' may not penetrate through the uppermost gate electrode 130U'. However, in some example embodiments, the contact plug 170f connected to the uppermost gate electrode 130U' may also have a shape similar to that of the other contact plugs 170.

Referring to FIG. 8B, a semiconductor device 100g may include a first semiconductor structure S1 and a second semiconductor structure S2 bonded to each other by a wafer bonding method.

The description of the peripheral circuit region PERI described above with reference to FIG. 2A may be applied to the first semiconductor structure S1. However, the first semiconductor structure S1 may further include first bonding vias 295, first bonding metal layers 298, and first bonding insulating layer 299, which are a bonding structure. The first bonding vias 295 may be above the uppermost circuit interconnection lines 280 and may be connected to the circuit interconnection lines 280. At least a portion of the first bonding metal layers 298 may be connected to the first bonding vias 295 on the first bonding vias 295. The first bonding metal layers 298 may be connected to the second bonding metal layers 198 of the second semiconductor structure S2. The bonding metal layers 298 may provide an electrical connection path according to bonding between the first semiconductor structure S1 and the second semiconductor structure S2 together with the second bonding metal layers 198. A portion of the first bonding metal layers 298 may be only for bonding without being connected to the lower circuit interconnection lines 280. The first bonding vias 295 and the first bonding metal layers 298 may include a conductive material such as copper (Cu). A first bonding insulating layer 299 may be around the first bonding metal layers 298. The first bonding insulating layer 299 may also function as a diffusion barrier of the first bonding metal layers 298, and may include, e.g., SiN, SiON, SiCN, SiOC, SiOCN, or SiO. As used herein, the term "or" is not an exclusive term, e.g., "A or B" would include A, B, or A and B.

As for the second semiconductor structure S2, unless otherwise indicated, the description of the memory cell region CELL described above with reference to FIGS. 1 to 3B may be applied. The second semiconductor structure S2 may further include cell interconnection lines 185, which is a cell interconnection structure, and may further include second bonding vias 195, second bonding metal layers 198, and second bonding insulating layer 199, which are a bonding structure. The second semiconductor structure S2 may further include a passivation layer 106 covering an upper surface of the plate layer 101.

The cell interconnection lines 185 may be connected to the studs 180. However, in example embodiments, the number of layers of plugs and interconnection lines included in the cell interconnection structure and the arrangement form thereof may be varied. The cell interconnection lines 185 may be formed of a conductive material, and may include, e.g., tungsten (W), aluminum (Al), or copper (Cu).

The second bonding vias 195 and the second bonding metal layers 198 may be below the lowermost cell interconnection lines 185. The second bonding vias 195 may connect the cell interconnection lines 185 to the second bonding metal layers 198, and the second bonding metal layers 198 may be bonded to the first bonding metal layers 298 of the first semiconductor structure S1. The second bonding insulating layer 199 may be bonded and connected to the first bonding insulating layer 299 of the first semiconductor structure S1. The second bonding vias 195 and the second bonding metal layers 198 may include a conductive material such as copper (Cu). The second bonding insulating layer 199 may include, e.g., SiO, SiN, SiCN, SiOC, SiON, or SiOCN.

The first and second semiconductor structures S1 and S2 may be bonded to each other by bonding between the first bonding metal layers 298 and the second bonding metal layers 198 and bonding between the first bonding insulating layer 299 and the second bonding insulating layer 199. The bonding between the first bonding metal layers 298 and the second bonding metal layers 198 may be, e.g., copper (Cu)-to-copper (Cu) bonding, and the bonding between the first bonding insulating layer 299 and the second bonding insulating layer 199 may be, e.g., dielectric-to-dielectric bonding such as SiCN-to-SiCN bonding. The first and second semiconductor structures S1 and S2 may be bonded to each other by hybrid bonding including copper (Cu)-to-copper (Cu) bonding and dielectric-to-dielectric bonding.

The passivation layer 106 may be on an upper surface of the plate layer 101 and may protect the semiconductor device 100g. The passivation layer 106 may include an insulating material, e.g., silicon oxide, silicon nitride, or silicon carbide. The substrate insulating layer 121 may be relatively widely disposed in the second region R2 to cover upper ends of the contact plugs 170. However, in example embodiments, the arrangement of the substrate insulating layer 121 may be varied in a range of electrically isolating the contact plugs 170 from the plate layer 101.

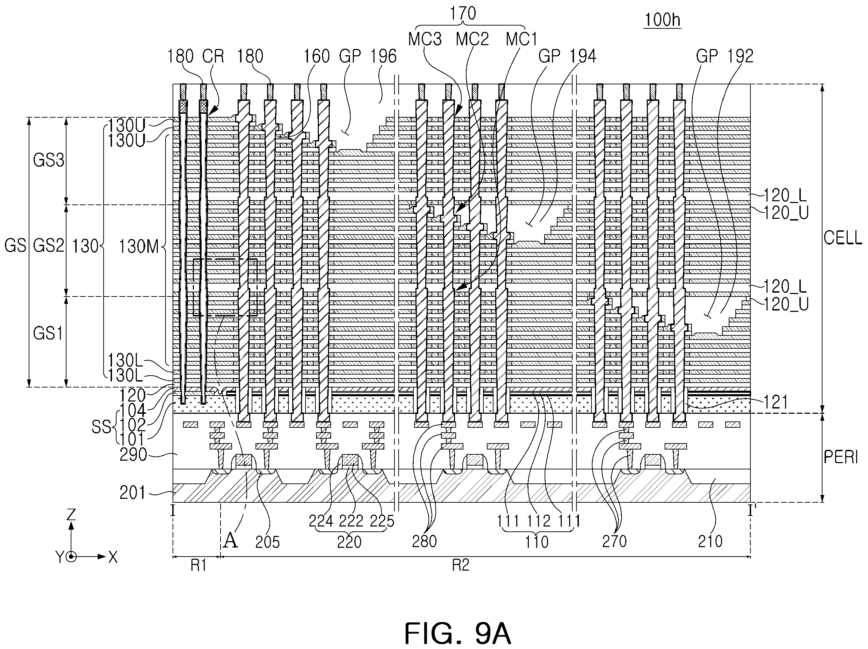

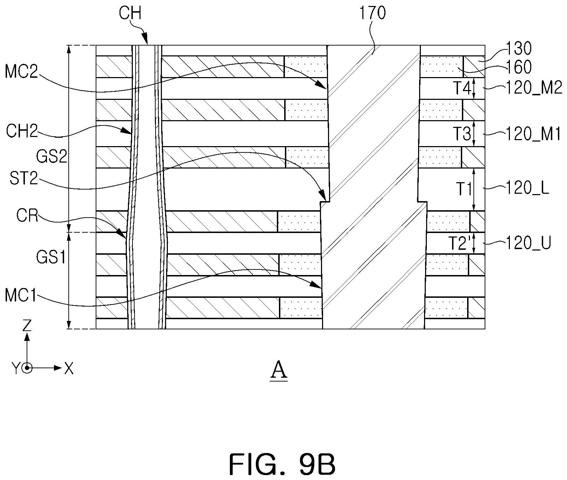

FIGS. 9A and 9B show cross-sectional views of a semiconductor device according to an example embodiment, showing regions corresponding to FIGS. 2A and 3A.

Referring to FIGS. 9A and 9B, in the semiconductor device 100h, the relative thickness of the uppermost interlayer insulating layers 120_U of the first and second stack structures GS1 and GS2, and the shape of a connecting portion of the channel structures CH may be different from the example embodiment in FIGS. 2A and 3B.

As shown in FIG. 9B, the uppermost interlayer insulating layer 120_U of the first stack structure GS1 may have a second thickness T2' smaller than the first thickness T1 of the adjacent lowermost interlayer insulating layer 120_L of the second stack structure GS2. In the example embodiment, the second thickness T2' may be substantially the same as the fourth thickness T4 of the interlayer insulating layer 120_M2 between the gate electrodes 130 of the intermediate regions of the first and second stack structures GS1 and GS2. The third thickness T3 of the interlayer insulating layer 120_M1 disposed adjacently above the lowermost interlayer insulating layer 120_L may be smaller than the first thickness T1 and may be equal to or larger than the fourth thickness T4. Accordingly, in the example embodiment, the first thickness T1 of the lowermost interlayer insulating layer 120_L among the interlayer insulating layers 120 may be the largest. The description of the thickness relationship of the interlayer insulating layers 120 may be equally applied to a region including an interfacial surface between the second stack structure GS2 and the third stack structure GS3.

In the channel structure CH, a connecting portion CR between the first channel portion CH1 and the second channel portion CH2 may not be distinct differently from the first bent portion ST1 in the example embodiment of FIG. 3A. The channel structure CH may have a shape in which a width thereof may slightly decrease toward the connecting portion CR from an upper portion. In some example embodiments, a width of the channel structure CH may not decrease in the connecting portion CR. In some example embodiments, a width of the channel structure CH may increase in the connecting portion CR going from the second channel portion CH2 towards the first channel portion CH1. In some example embodiments, the second bent portion ST2 of the contact plug 170 may have a shape in which the second bent portion ST2 may not be distinct similarly to the channel structure CH.

The relative thickness of the uppermost interlayer insulating layers 120_U of the example embodiment, and the shape of the connecting portion CR of the channel structures CH may be independently combined with other example embodiments.

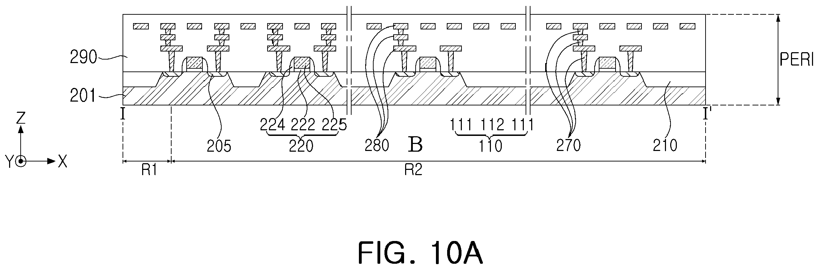

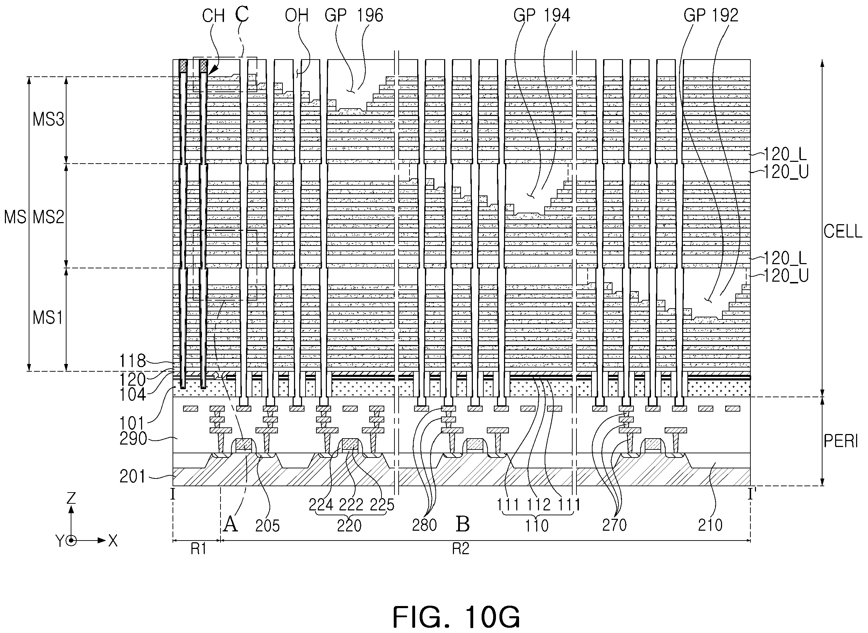

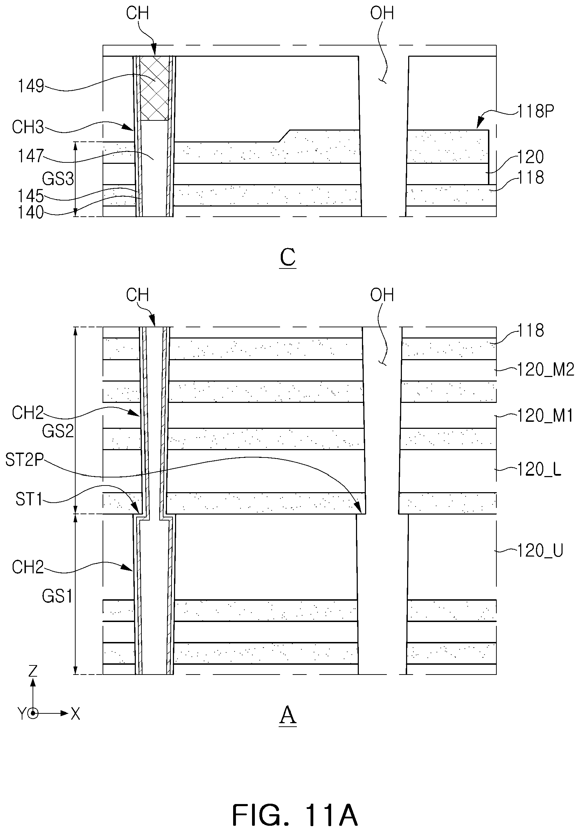

FIGS. 10A to 10K and 11A to 11D show cross-sectional views of stages in a method of manufacturing a semiconductor device according to an example embodiment. FIGS. 10A to 10K show cross-sectional views corresponding to FIG. 2A, and FIGS. 11A to 11D show enlarged diagrams of regions corresponding to region "C" and "A" in FIGS. 10G to 10J.

Referring to FIG. 10A, circuit devices 220, a circuit interconnection structure, and a peripheral region insulating layer 290 included in a peripheral circuit region PERI may be formed on a substrate 201.

First, device isolation layers 210 may be formed in the substrate 201, and a circuit gate dielectric layer 222 and a circuit gate electrode 225 may be formed in order on the substrate 201. The device isolation layers 210 may be formed by, e.g., a shallow trench isolation (STI) process. The circuit gate dielectric layer 222 and the circuit gate electrode 225 may be formed using atomic layer deposition (ALD) or chemical vapor deposition (CVD). The circuit gate dielectric layer 222 may be formed of silicon oxide, and the circuit gate electrode 225 may be formed of, e.g., polycrystalline silicon or a metal silicide layer. Thereafter, a spacer layer 224, and impurity regions 205 may be formed on both sidewalls of the circuit gate dielectric layer 222 and the circuit gate electrode 225. In example embodiments, the spacer layer 224 may include a plurality of layers. The impurity regions 205 may be formed by performing an ion implantation process.

Among the circuit interconnection structures, the circuit contact plugs 270 may be formed by forming a portion of the peripheral region insulating layer 290, removing a portion by etching, and filling in a conductive material. The circuit interconnection lines 280 may be formed by, e.g., depositing a conductive material and patterning the material.

The peripheral region insulating layer 290 may include a plurality of insulating layers. The peripheral region insulating layer 290 may become a portion in each of the processes of forming the circuit interconnection structure. Accordingly, a peripheral circuit region PERI may be formed.

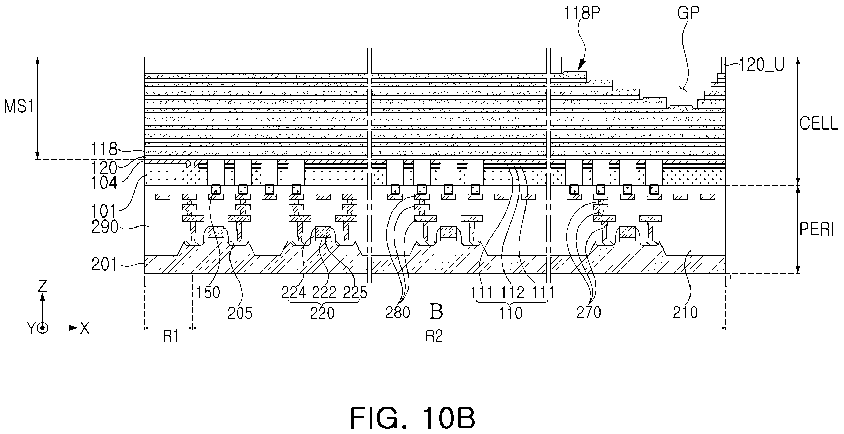

Referring to FIG. 10B, a plate layer 101 provided with a memory cell region CELL, a horizontal insulating layer 110, a second horizontal conductive layer 104, and a substrate insulating layer 121 may be formed on the peripheral circuit region PERI, a first mold structure MS1 may be formed by alternately stacking sacrificial insulating layers 118 and interlayer insulating layers 120, and a gate pad region GP may be formed.

The plate layer 101 may be formed on the peripheral region insulating layer 290. The plate layer 101 may be formed of, e.g., polycrystalline silicon and may be formed by a CVD process. Polycrystalline silicon included in the plate layer 101 may include impurities.

When the plate layer 101 is formed, landing pads 150 may be formed together on the uppermost circuit interconnection lines 280. The landing pads 150 may be formed in a region in which a lower end of the contact plugs 170 (see FIG. 2A) is disposed. First, before the plate layer 101 is formed, openings may be formed by partially removing the peripheral region insulating layer 290 on the uppermost circuit interconnection lines 280. When the plate layer 101 is formed, the landing pads 150 may be formed by filling the openings with a material included in the plate layer 101. The openings may be formed together with ground vias for connecting the plate layer 101 and the circuit interconnection structure.

First and second horizontal insulating layers 111 and 112 included in the horizontal insulating layer 110 may be alternately stacked on the plate layer 101. A portion of the horizontal insulating layer 110 may be replaced with the first horizontal conductive layer 102 in FIG. 2A through a subsequent process. The first horizontal insulating layers 111 may include a material different from that of the second horizontal insulating layer 112. In an implementation, the first horizontal insulating layers 111 may be formed of the same material as that of the interlayer insulating layers 120, and the second horizontal insulating layer 112 may be formed of the same material as that of the sacrificial insulating layers 118 subsequently formed. A portion of the horizontal insulating layer 110 may be removed by a patterning process in partial regions, e.g., in the second region R2.

The second horizontal conductive layer 104 may be formed on the horizontal insulating layer 110 and may be in contact with the plate layer 101 in a region from which the horizontal insulating layer 110 is removed.

The substrate insulating layer 121 may be formed to penetrate the plate layer 101 in partial regions including a region in which the contact plugs 170 are disposed. The substrate insulating layer 121 may be formed by removing a portion of the plate layer 101, the horizontal insulating layer 110, and the second horizontal conductive layer 104 and filling the insulating material. After the insulating material is buried, a planarization process may be further performed using a chemical mechanical polishing (CMP) process. Accordingly, an upper surface of the substrate insulating layer 121 may be substantially coplanar with an upper surface of the second horizontal conductive layer 104.

Thereafter, the first mold structure MS1 may be formed on the second horizontal conductive layer 104 and the substrate insulating layer 121 on a level on which the first stack structure GS1 (see FIG. 2A) is disposed.

At least a portion of the sacrificial insulating layers 118 may be replaced with gate electrodes 130 (see FIG. 2A) through a subsequent process. The sacrificial insulating layers 118 may be formed of a material different from that of the interlayer insulating layers 120, and may be formed of a material that may be etched with etch selectivity under specific etching conditions with respect to the interlayer insulating layers 120. In an implementation, the interlayer insulating layer 120 may be formed of, e.g., silicon oxide or silicon nitride, and the sacrificial insulating layers 118 may be formed of a material different from that of the interlayer insulating layer 120, e.g., silicon, silicon oxide, silicon carbide, or silicon nitride. In example embodiments, thicknesses of the interlayer insulating layers 120 may not be the same as described above with reference to FIGS. 1 to 3B. In an implementation, the uppermost interlayer insulating layer 120_U may have a relatively large thickness. The number of interlayer insulating layers 120 and the sacrificial insulating layers 118 may be varied from the illustrated example.

The gate pad region GP may be formed by repeatedly performing a photolithography process and an etching process for the sacrificial insulating layers 118 and the interlayer insulating layers 120. The gate pad regions GP may be formed in the second region R2, and may be formed to include a region in which the upper sacrificial insulating layers 118 may extend shorter than the lower sacrificial insulating layers 118. In the gate pad region GP, asymmetric step structures may be formed such that upper surfaces and ends of the plurality of sacrificial insulating layers 118 may be exposed upwardly. However, in example embodiments, the specific shape of the gate pad region GP may be varied.

By further forming sacrificial insulating layers 118 on the step structure of gate pad regions GP, the sacrificial insulating layers 118 on an uppermost portion in each region may form preliminary contact regions 118P having a relatively thick thickness. The preliminary contact regions 118P may be formed on the step structure on the left side, that is, the first step structure, in which a slope of the step structure may be relatively gentle, and may not be formed on the step structure, that is, the second step structure, on the right side, in which a slope of the step structure may be relatively steep. However, in some example embodiments, the preliminary contact regions 118P may be formed in both the first and second step structures.

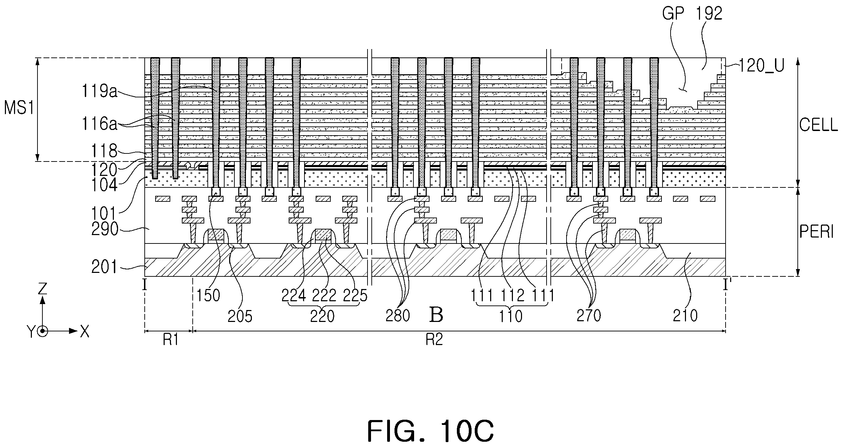

Referring to FIG. 10C, first channel sacrificial layers 116a and first contact sacrificial layers 119a penetrating through the first mold structure MS1 may be formed.

First, a first cell region insulating layer 192 covering first mold structure MS1 may be formed. The first channel sacrificial layers 116a may be formed in positions corresponding to the channel structures CH (see FIG. 2A) in the first region R1. The first contact sacrificial layers 119a may be formed in positions corresponding to the contact plugs 170 (see FIG. 2A) in the second region R2. The first channel sacrificial layers 116a and the first contact sacrificial layers 119a may be formed simultaneously.

The first channel sacrificial layers 116a and the first contact sacrificial layers 119a may be formed by forming first holes to penetrate through the first mold structure MS1, depositing a sacrificial layer material on the first holes, and performing a planarization process. The first channel sacrificial layers 116a and the first contact sacrificial layers 119a may include, e.g., TiN or polycrystalline silicon.

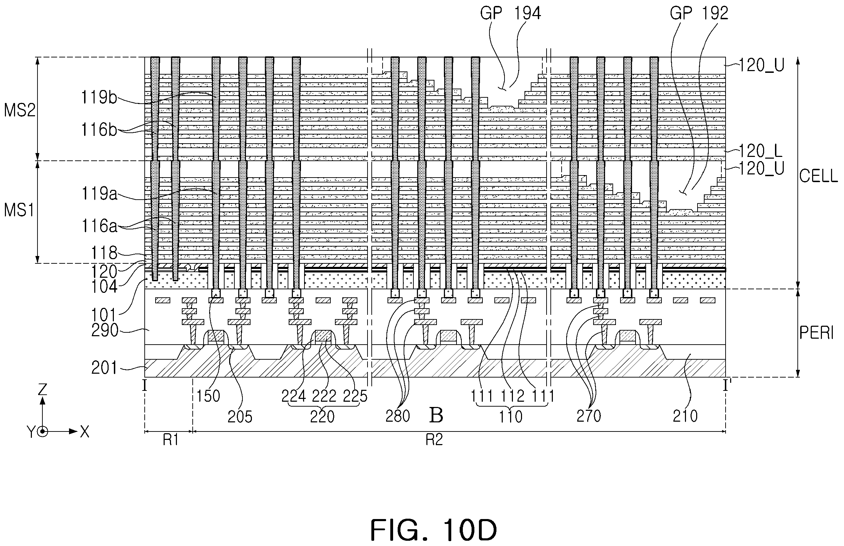

Referring to FIG. 10D, second mold structure MS2 may be formed by alternately stacking the sacrificial insulating layers 118 and the interlayer insulating layers 120 on the first mold structure MS1, and the second channel sacrificial layers 116b and the second contact sacrificial layers 119b may be formed.

The second mold structure MS2 may be formed on first mold structure MS1 in the same manner as the first mold structure MS1. The second mold structure MS2 may start with the sacrificial insulating layer 118. The lowermost interlayer insulating layer 120_L on the lowermost sacrificial insulating layer 118 may have a thickness smaller than that of the uppermost interlayer insulating layer 120_U of the first mold structure MS1 and larger than those of the other interlayer insulating layers 120.

Since the second mold structure MS2 in the example embodiment may start with the sacrificial insulating layer 118, the lowermost interlayer insulating layer 120_L thereon may be formed to have a relatively thick thickness. In the comparative example, when the second mold structure MS2 starts with the interlayer insulating layer 120, the total thickness of the insulating layer may be excessively increased together with the uppermost interlayer insulating layer 120_U of the first mold structure MS1 thereunder, which may cause other design difficulties.

After the gate pad region GP is formed on the second mold structure MS2, a second cell region insulating layer 194 covering the second mold structure MS2 may be formed. The second channel sacrificial layers 116b may be formed to be connected to the first channel sacrificial layers 116a, respectively, and the second contact sacrificial layers 119b may be formed to be connected to the first contact sacrificial layers 119a, respectively. The second channel sacrificial layers 116b and the second contact sacrificial layers 119b may be formed simultaneously. The second channel sacrificial layers 116b and the second contact sacrificial layers 119b may be formed by depositing the same material as that of the first channel sacrificial layers 116a and the first contact sacrificial layers 119a.

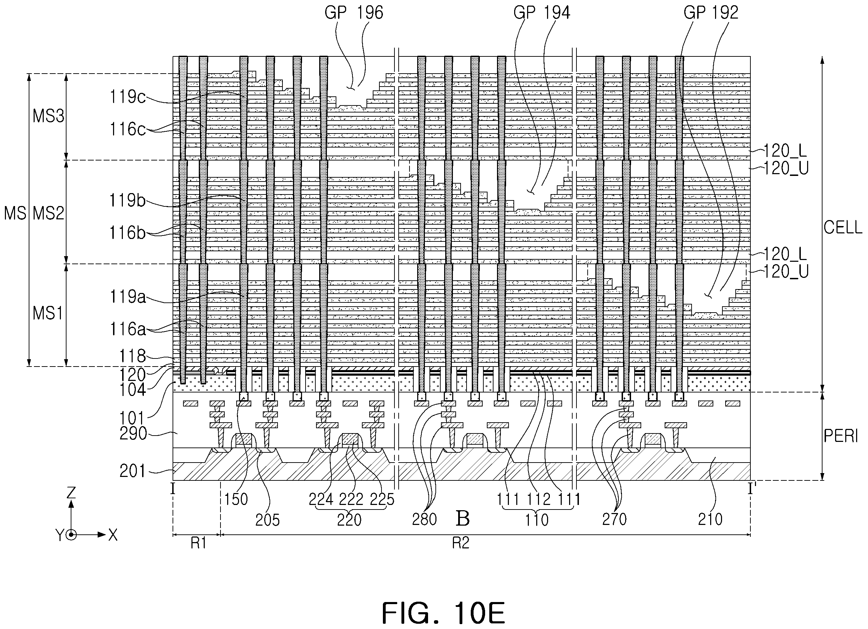

Referring to FIG. 10E, a third mold structure MS3 may be formed by alternately stacking the sacrificial insulating layers 118 and the interlayer insulating layers 120 on the second mold structure MS2, a gate pad region GP may be formed, and a third channel sacrificial layers 116c and third contact sacrificial layers 119c may be formed.

The third mold structure MS3 may be formed on the second mold structure MS2 in the same manner as the first and second mold structures MS1 and MS2. After the gate pad region GP is formed on the third mold structure MS3, a third cell region insulating layer 196 covering the third mold structure MS3 may be formed.

The third channel sacrificial layers 116c may be formed to be connected to the second channel sacrificial layers 116b, respectively, and the third contact sacrificial layers 119c may be formed to be connected to the second contact sacrificial layers 119b, respectively. The third channel sacrificial layers 116c and the third contact sacrificial layers 119c may be formed simultaneously. The third channel sacrificial layers 116c and third contact sacrificial layers 119c may be formed by depositing the same material as that of the first and second channel sacrificial layers 116a and 116b and the first and second contact sacrificial layers 119a and 119b.

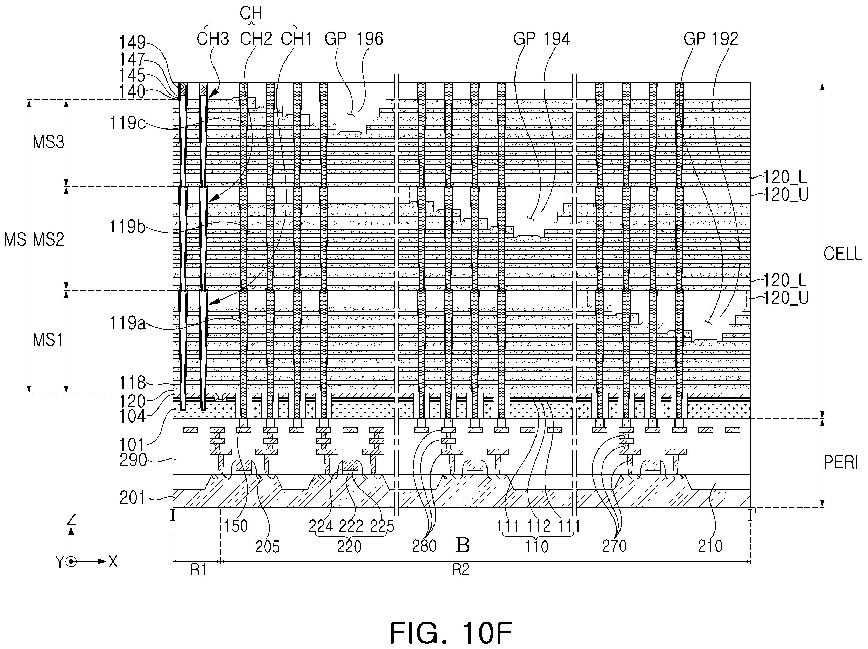

Referring to FIG. 10F, channel structures CH penetrating the first to third mold structures MS1, MS2, and MS3 may be formed.

The channel structures CH may be formed by forming channel holes by removing the first to third channel sacrificial layers 116a, 116b, and 116c, and sequentially depositing at least a portion of a gate dielectric layer 145, a channel layer 140, a channel buried insulating layer 147 and a channel pad 149 in the channel holes.

The gate dielectric layer 145 may be formed to have a uniform thickness using an ALD or CVD process. In this process, the entirety or a portion of the gate dielectric layer 145 may be formed, and a portion extending perpendicular to the plate layer 101 along channel structures CH may be formed in this process. A channel layer 140 may be formed on the gate dielectric layer 145 in the channel holes. The channel buried insulating layer 147 may be formed to fill the channel holes and may be an insulating material. The channel pad 149 may be formed of a conductive material, e.g., polycrystalline silicon.

Accordingly, the channel structures CH each including the first to third channel portions CH1, CH2, and CH3 may be formed.

Referring to FIGS. 10G and 11A, first contact holes OH may be formed by removing the first to third contact sacrificial layers 119a, 119b, and 119c.

The first contact holes OH may be formed by selectively removing the first to third contact sacrificial layers 119a, 119b, and 119c and further removing the exposed landing pads 150. The circuit interconnection lines 280 may be exposed through the bottom surfaces of the first contact holes OH. In some example embodiments, the landing pads 150 may not be removed in this process and may be removed in a subsequent process.

As shown in FIG. 11A, each of the first contact holes OH may have preliminary second bent portions ST2P corresponding to an interfacial surface between the first to third contact sacrificial layers 119a, 119b, and 119c. In this process, a level of preliminary second bent portions ST2P may be substantially the same as a level of first bent portions ST1 between the first to third channel portions CH1, CH2, and CH3 of the channel structures CH.

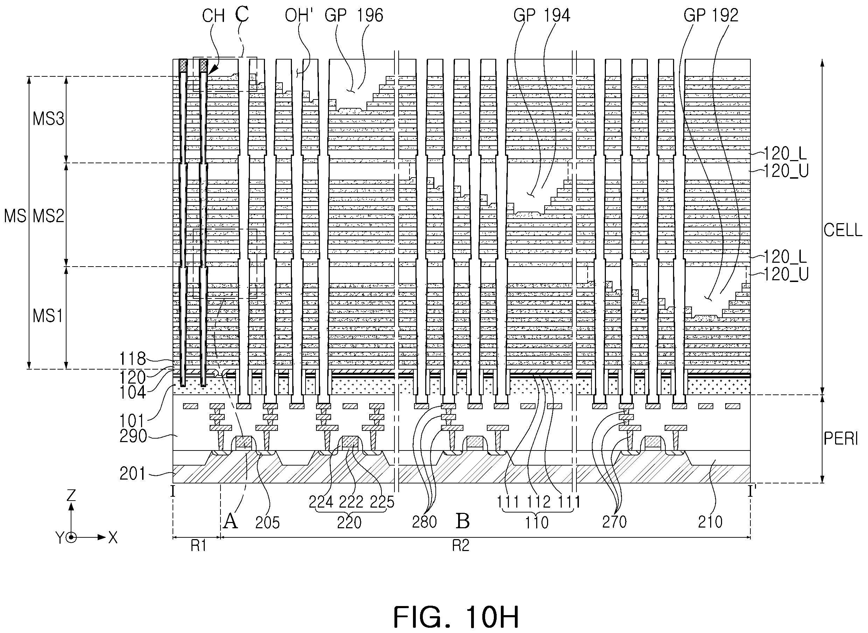

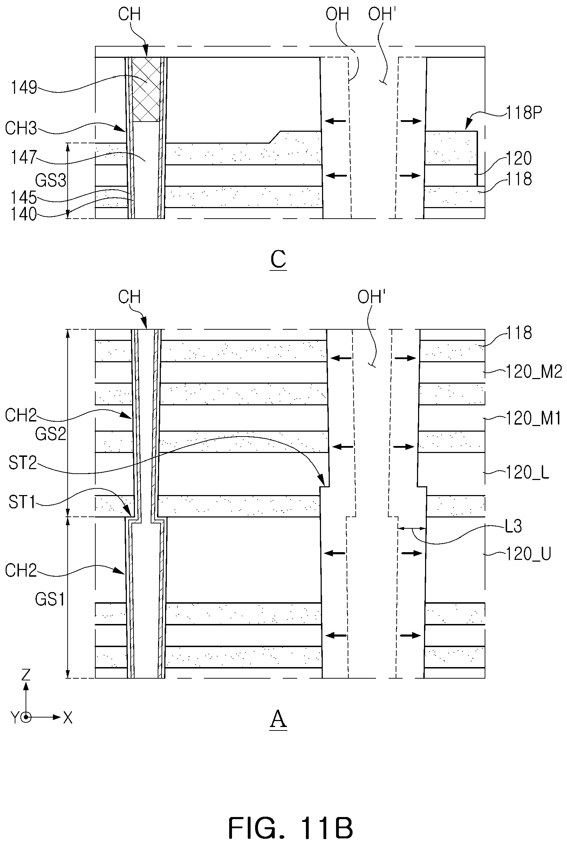

Referring to FIGS. 10H and 11B, the first contact holes OH may expand to form a second contact holes OH'.

The second contact holes OH' may be formed by expanding the first contact holes OH in horizontal and vertical directions using, e.g., a wet etching process. The wet etching process may include a primary etching process for the interlayer insulating layers 120, the first to third cell region insulating layers 192, 194, and 196, and the peripheral region insulating layer 290 and a secondary etching process for the sacrificial insulating layers 118. The length L3 by which the first contact holes OH extends to one side by the wet etching process may be, e.g., in the range of about 30% to about 60% (e.g. 30% to 60%) of a width or a diameter of the first contact hole OH, but the length may be varied in the example embodiments.

By this process, each of the second contact holes OH' may have second bent portions ST2 on a level higher than a level of the first bent portions ST1.

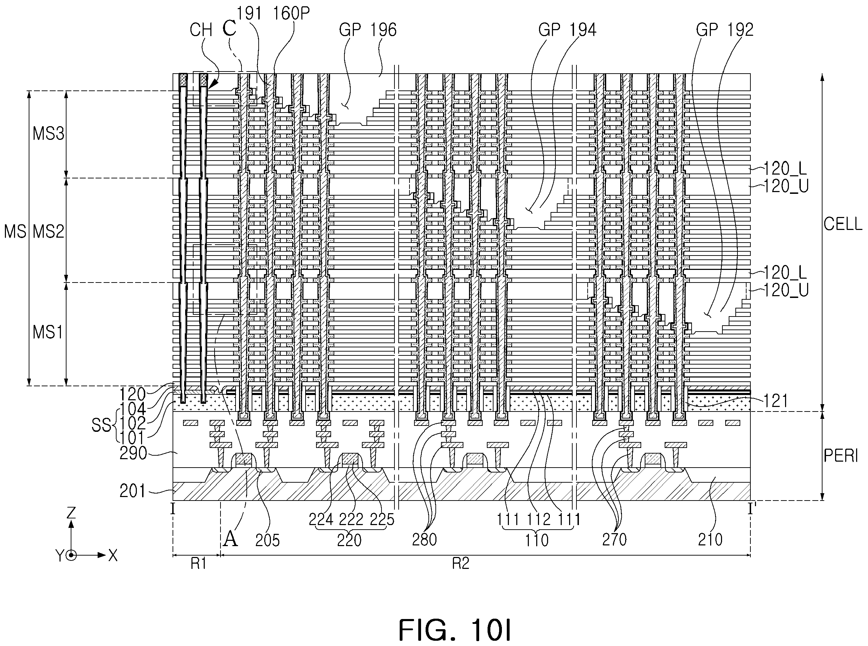

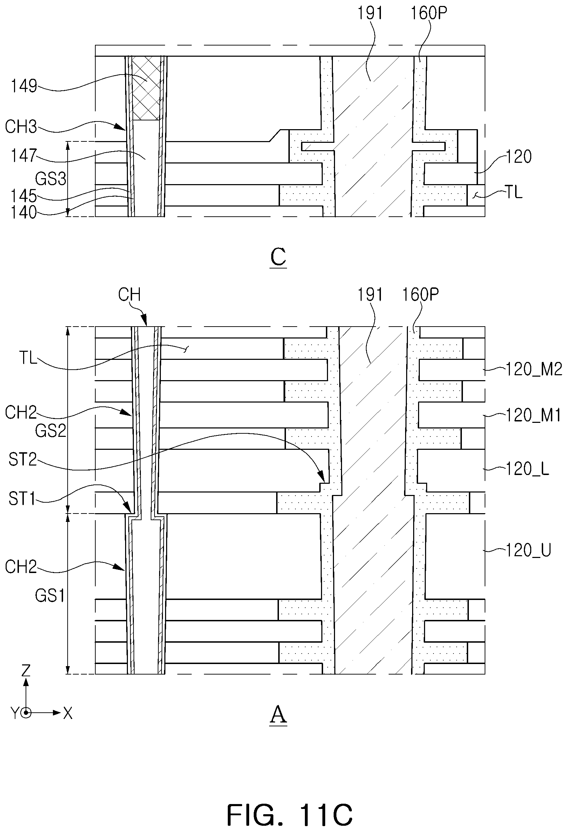

Referring to FIGS. 10I and 11C, the preliminary contact insulating layers 160P and the vertical sacrificial layers 191 may be formed on the second contact holes OH', and the sacrificial insulating layers 118 may be removed.

First, a portion of the sacrificial insulating layers 118 exposed through the second contact holes OH' may be removed. Contact tunnel portions may be formed by removing the sacrificial insulating layers 118 to a predetermined length around the second contact holes OH'. The contact tunnel portions may be formed to have a relatively short length in the uppermost sacrificial insulating layers 118 and to have a relatively long length in the lower sacrificial insulating layers 118.

Specifically, initially, the contact tunnel portions may be formed relatively long in the uppermost sacrificial insulating layers 118, which may be because the uppermost sacrificial insulating layers 118 may include a region having a relatively faster etching rate than the sacrificial insulating layers 118 thereunder. Thereafter, another sacrificial layer may be formed in the second contact holes OH' and the contact tunnel portions. The sacrificial layer may be formed of a material having a slower etching rate than that of the material of the sacrificial insulating layers 118. Thereafter, a portion of the sacrificial layer and sacrificial insulating layers 118 may be removed, and in this case, the sacrificial layer may remain in an uppermost portion, and the sacrificial layer may be removed from a lower portion, and a portion of the sacrificial insulating layers 118 may be removed. Accordingly, finally, the contact tunnel portions may be formed to have a relatively short length in the uppermost sacrificial insulating layers 118.

Preliminary contact insulating layers 160P may be formed by depositing an insulating material in the second contact holes OH' and the contact tunnel portions. The preliminary contact insulating layers 160P may be formed on the sidewall of the second contact holes OH' and may fill the contact tunnel portions. In the uppermost sacrificial insulating layers 118, the preliminary contact insulating layers 160P may not completely fill the contact tunnel portions.

The vertical sacrificial layers 191 may fill the second contact holes OH' and may also fill the contact tunnel portions in an uppermost portion. The second contact holes OH' may include a material different from that of the preliminary contact insulating layers 160P, e.g., polycrystalline silicon.

Thereafter, openings penetrating through the sacrificial insulating layers 118 and the interlayer insulating layers 120 and extending to the plate layer 101 may be formed in a position of the first isolation regions MS (see FIGS. 1 and 2B). Thereafter, by performing an etch-back process while forming sacrificial spacer layers in the openings, the horizontal insulating layer 110 may be selectively removed from the first region R1, and a portion of the exposed gate dielectric layer 145 may also be removed. A first horizontal conductive layer 102 may be formed by depositing a conductive material in the region from which the horizontal insulating layer 110 is removed, and the sacrificial spacer layers may be removed from the openings. Through this process, a first horizontal conductive layer 102 may be formed in the first region R1.

Thereafter, the sacrificial insulating layers 118 may be selectively removed with respect to the interlayer insulating layers 120, the second horizontal conductive layer 104, and the preliminary contact insulating layers 160P by using, e.g., wet etching, thereby forming gate tunnel portions TL.

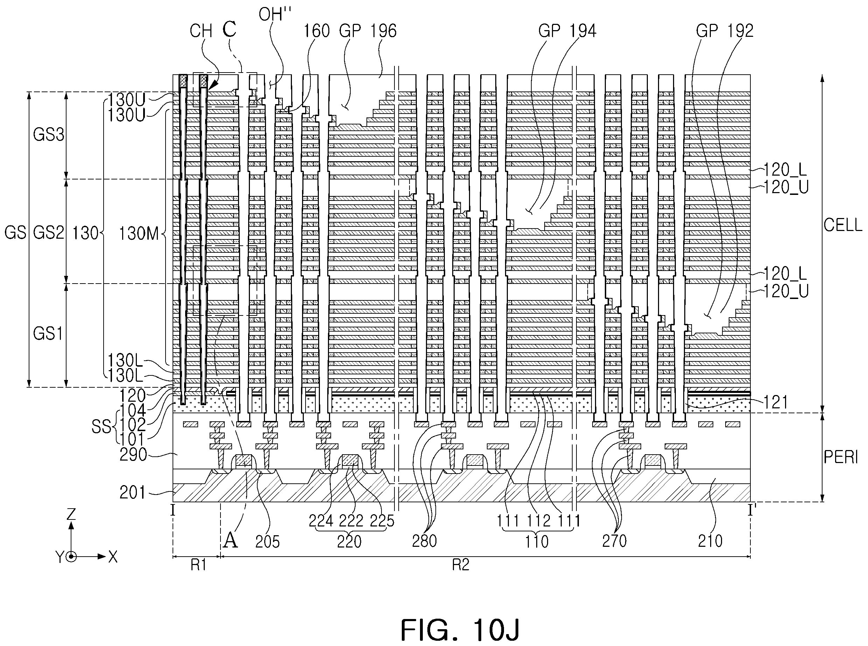

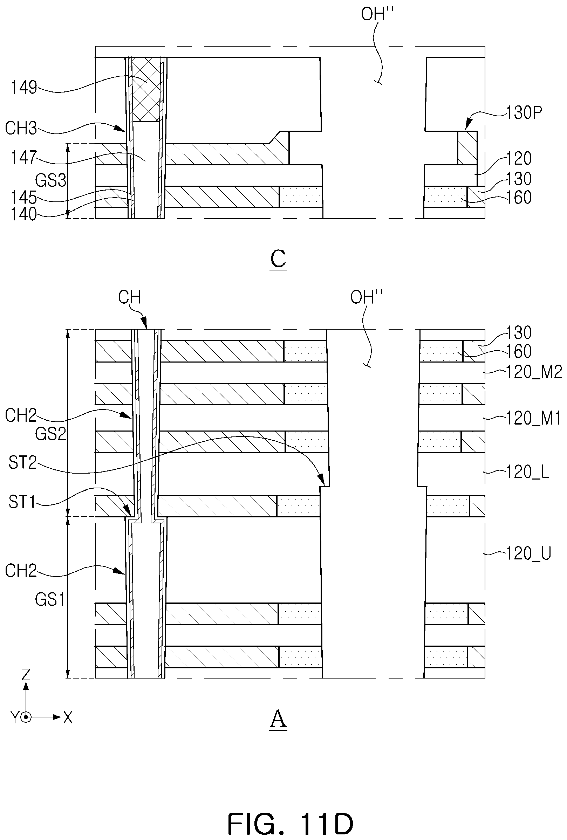

Referring to FIGS. 10J and 11D, gate electrodes 130 may be formed in the gate tunnel portions TL, and third contact holes OH" may be formed by removing the vertical sacrificial layers 191.

The gate electrodes 130 may be formed by depositing a conductive material in the gate tunnel portions TL. The conductive material may include metal, polycrystalline silicon, or metal silicide material. In some example embodiments, a portion of the gate dielectric layer 145 may be preferentially formed before the gate electrodes 130 is formed. Accordingly, a gate structure GS including the first to third stack structures GS1, GS2, and GS3 may be formed.

The gate electrodes 130 may be formed, and gate isolation insulating layers 105 (see FIG. 2B) may be formed in the openings formed to correspond to the first isolation regions MS.

The vertical sacrificial layers 191 may be selectively removed with respect to the interlayer insulating layers 120 and the gate electrodes 130. After the vertical sacrificial layers 191 are removed, a portion of the exposed preliminary contact insulating layers 160P may also be removed. In this case, the entirety of the preliminary contact insulating layers 160P may be removed from the contact regions 130P, and the preliminary contact insulating layers 160P may remain thereunder and may form the contact insulating layers 160. In the contact regions 130P, when the gate dielectric layer 145 is exposed after the preliminary contact insulating layers 160P are removed, the gate dielectric layer 145 may also be removed to expose a side surface of the gate electrodes 130.

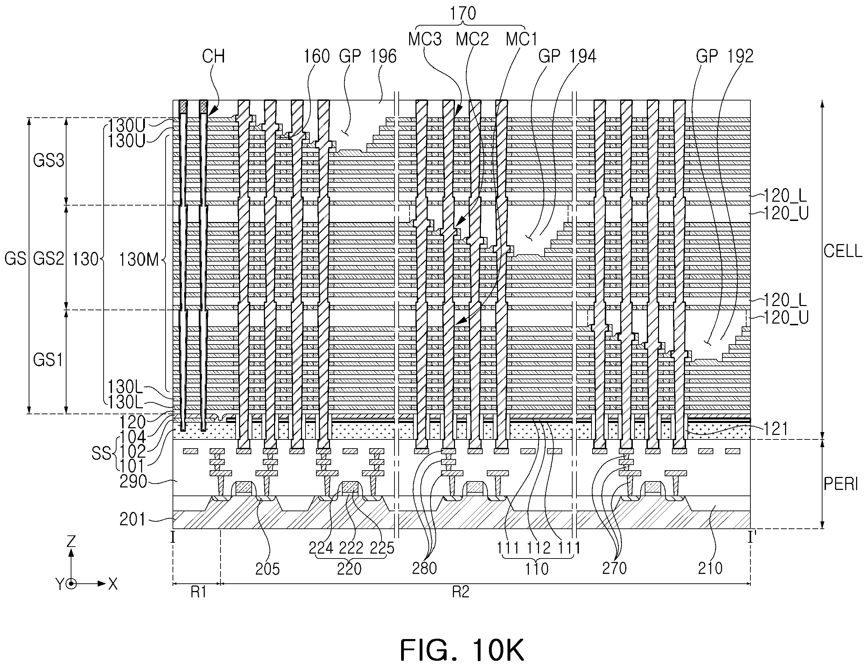

Referring to FIG. 10K, contact plugs 170 may be formed.

The contact plugs 170 may be formed by depositing a conductive material in the third contact holes OH". The contact plugs 170 may be formed to have horizontal extension portions 170H (see FIG. 3B) extending horizontally from contact regions 130P, and accordingly, the contact plugs 170 may be physically and electrically connected to the gate electrodes 130.

Thereafter, referring to FIG. 2A together, by forming the contact plugs 170 and studs 180 connected to upper ends of channel structures CH, the semiconductor device 100 may be manufactured.

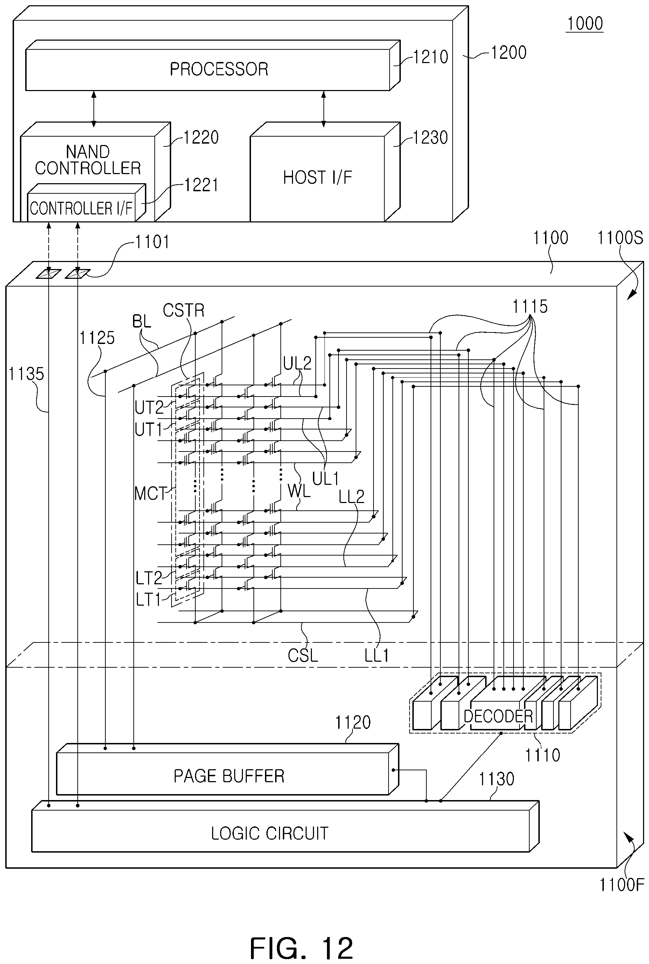

FIG. 12 shows a view of a data storage system including a semiconductor device according to an example embodiment.

Referring to FIG. 12, a data storage system 1000 may include a semiconductor device 1100 and a controller 1200 electrically connected to the semiconductor device 1100. The data storage system 1000 may be implemented as a storage device including one or a plurality of semiconductor devices 1100 or an electronic device including a storage device. In an implementation, the data storage system 1000 may be implemented as a solid state drive device (SSD) including one or a plurality of semiconductor devices 1100, a universal serial bus (USB), a computing system, a medical device, or a communication device.

The semiconductor device 1100 may be implemented as a non-volatile memory device, such as, e.g., the NAND flash memory device described in the aforementioned example embodiment with reference to FIGS. 1 to 9B. The semiconductor device 1100 may include a first structure 1100F and a second structure 1100S on the first structure 1100F. In the example embodiments, the first structure 1100F may be on the side of the second structure 1 1005. The first structure 1100F may be implemented as a peripheral circuit structure including a decoder circuit 1110, a page buffer 1120, and a logic circuit 1130. The second structure 1 100S may be implemented as a memory cell structure including a bit line BL, a common source line CSL, word lines WL, first and second gate upper lines UL1 and UL2, first and second gate lower lines LL1 and LL2 and memory cell strings CSTR between the bit line BL and the common source line CSL.

In the second structure 1100S, each of the memory cell strings CSTR may include lower transistors LT1 and LT2 adjacent to the common source line CSL, upper transistors UT1 and UT2 adjacent to the bit line BL, and a plurality of memory cell transistors MCT between the lower transistors LT1 and LT2 and the upper transistors UT1 and UT2. The number of lower transistors LT1 and LT2 and the number of upper transistors UT1 and UT2 may be varied in the example embodiments.

In the example embodiments, the upper transistors UT1 and UT2 may include a string select transistor, and the lower transistors LT1 and LT2 may include a ground select transistor. The gate lower lines LL1 and LL2 may be configured as gate electrodes of the lower transistors LT1 and LT2, respectively. The word lines WL may be configured as gate electrodes of the memory cell transistors MCT, and the gate upper lines UL1 and UL2 may be configured as gate electrodes of the upper transistors UT1 and UT2, respectively.

In the example embodiments, the lower transistors LT1 and LT2 may include a lower erase control transistor LT1 and a ground select transistor LT2 connected to each other in series. The upper transistors UT1 and UT2 may include a string select transistor UT1 and an upper erase control transistor UT2 connected to each other in series. At least one of the lower erase control transistor LT1 and the upper erase control transistor UT2 may be used in an erase operation for erasing data stored in the memory cell transistors MCT using a GIDL phenomenon.

The common source line CSL, the first and second gate lower lines LL1 and LL2, the word lines WL, and the first and second gate upper lines UL1 and UL2 may be electrically connected to the decoder circuit 1110 through first connection interconnections 1115 extending from the first structure 1100F to the second structure 1100S. The bit lines BL may be electrically connected to the page buffer 1120 through second connection interconnections 1125 extending from the first structure 110F to the second structure 1100S.

In the first structure 1100F, the decoder circuit 1110 and the page buffer 1120 may perform a control operation on at least one selected memory cell transistor among the plurality of memory cell transistors MCT. The decoder circuit 1110 and the page buffer 1120 may be controlled by the logic circuit 1130. The semiconductor device 1100 may communicate with the controller 1200 through the input/output pads 1101 electrically connected to the logic circuit 1130. The input/output pads 1101 may be electrically connected to the logic circuit 1130 through an input/output connection line 1135 extending from the first structure 1100F to the second structure 1100S.

The controller 1200 may include a processor 1210, a NAND controller 1220, and a host interface 1230. In the example embodiments, the data storage system 1000 may include a plurality of semiconductor devices 1100, and in this case, the controller 1200 may control the plurality of semiconductor devices 1100.

The processor 1210 may control overall operation of the data storage system 1000 including the controller 1200. The processor 1210 may operate according to a predetermined firmware, and may access the semiconductor device 1100 by controlling the NAND controller 1220. The NAND controller 1220 may include a controller interface 1221 processing communication with the semiconductor device 1100. Through the controller interface 1221, a control command for controlling the semiconductor device 1100, data to be written to the memory cell transistors MCT of the semiconductor device 1100, and data to be read from the memory cell transistors MCT of the semiconductor device 1100 may be transmitted. The host interface 1230 may provide a communication function between the data storage system 1000 and an external host. When a control command from an external host is received through the host interface 1230, the processor 1210 may control the semiconductor device 1100 in response to the control command.

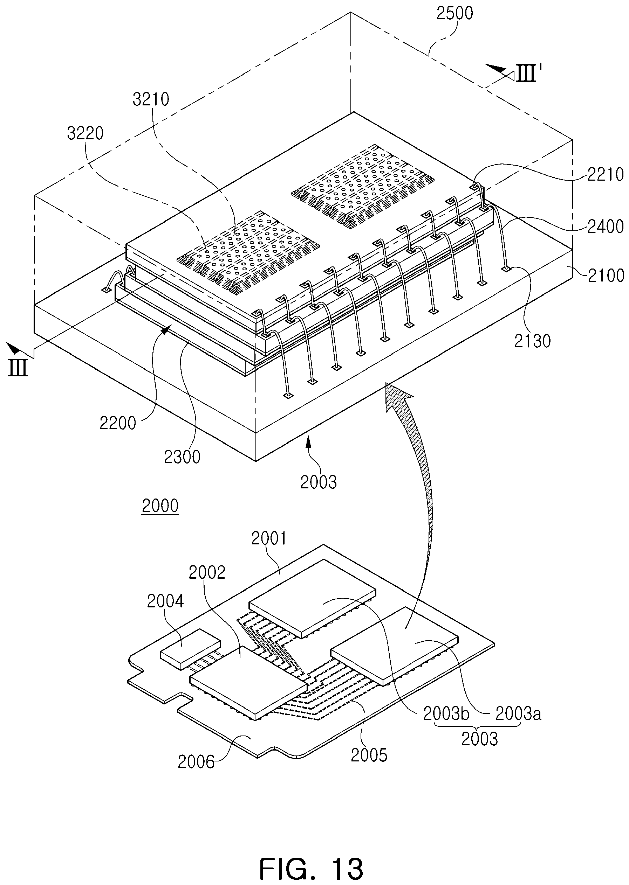

FIG. 13 shows a perspective view of a data storage system including a semiconductor device according to an example embodiment.

Referring to FIG. 13 a data storage system 2000 in an example embodiment may include a main board 2001, a controller 2002 mounted on the main board 2001, one or more semiconductor packages 2003, and a DRAM 2004. The semiconductor package 2003 and the DRAM 2004 may be connected to the controller 2002 by interconnection patterns 2005 formed on the main board 2001.

The main board 2001 may include a connector 2006 including a plurality of pins coupled to an external host. The number and arrangement of the plurality of pins in the connector 2006 may vary depending on a communication interface between the data storage system 2000 and the external host. In the example embodiments, the data storage system 2000 may communicate with an external host according to one of interfaces from among universal serial bus (USB), peripheral component interconnect express (PCI-Express), serial advanced technology attachment (SATA), M-Phy for universal flash storage (UFS). In the example embodiments, the data storage system 2000 may operate by power supplied from an external host through the connector 2006. The data storage system 2000 may further include a power management integrated circuit (PMIC) for distributing power supplied from the external host to the controller 2002 and the semiconductor package 2003.

The controller 2002 may write data to or may read data from the semiconductor package 2003, and may improve an operating speed of the data storage system 2000.

The DRAM 2004 may be configured as a buffer memory for alleviating a difference in speeds between the semiconductor package 2003, which is a data storage space, and an external host. The DRAM 2004 included in the data storage system 2000 may operate as a cache memory, and may provide a space for temporarily storing data in a control operation for the semiconductor package 2003. When the data storage system 2000 may include the DRAM 2004, the controller 2002 may further include a DRAM controller for controlling the DRAM 2004 in addition to the NAND controller for controlling the semiconductor package 2003.

The semiconductor package 2003 may include first and second semiconductor packages 2003a and 2003b spaced apart from each other. Each of the first and second semiconductor packages 2003a and 2003b may be configured as a semiconductor package including a plurality of semiconductor chips 2200. Each of the first and second semiconductor packages 2003a and 2003b may include a package substrate 2100, semiconductor chips 2200 on the package substrate 2100, adhesive layers 2300 on lower surfaces of the semiconductor chips 2200, respectively, a connection structure 2400 electrically connecting the semiconductor chips 2200 to the package substrate 2100, and a molding layer 2500 covering the semiconductor chips 2200 and the connection structure 2400 on the package substrate 2100.

The package substrate 2100 may be configured as a printed circuit board including package upper pads 2130. Each semiconductor chip 2200 may include an input/output pad 2210. The input/output pad 2210 may correspond to the input/output pad 1101 in FIG. 12. Each of the semiconductor chips 2200 may include gate stack structures 3210 and channel structures 3220. Each of the semiconductor chips 2200 may include the semiconductor device described in the aforementioned example embodiment with reference to FIGS. 1 to 9B.

In the example embodiments, the connection structure 2400 may be configured as a bonding wire electrically connecting the input/output pad 2210 to the package upper pads 2130. Accordingly, in each of the first and second semiconductor packages 2003a and 2003b, the semiconductor chips 2200 may be electrically connected to each other by a bonding wire method, and may be electrically connected to the package upper pads 2130 of the package substrate 2100. In the example embodiments, in each of the first and second semiconductor packages 2003a and 2003b, the semiconductor chips 2200 may be electrically connected to each other by a connection structure including a through-electrode (TSV) instead of the connection structure 2400 of a bonding wire method.

In the example embodiments, the controller 2002 and the semiconductor chips 2200 may be included in a single package. In an example embodiment, the controller 2002 and the semiconductor chips 2200 may be mounted on an interposer substrate different from the main board 2001, and the controller 2002 and the semiconductor chips 2200 may be connected to each other by interconnection formed on the interposer substrate.

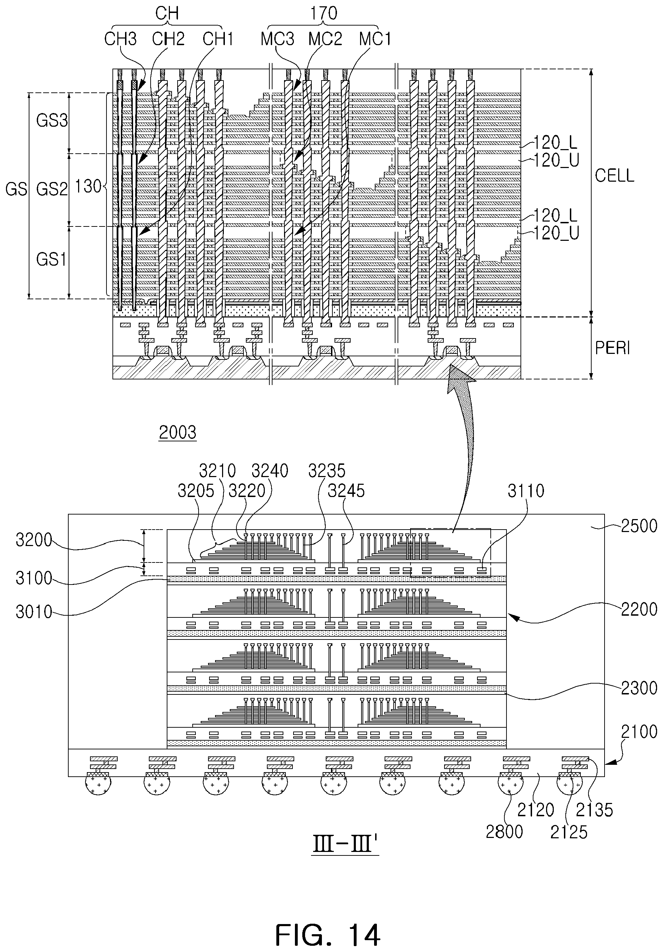

FIG. 14 shows a cross-sectional view of a semiconductor package according to an example embodiment, showing an example embodiment of the semiconductor package 2003 in FIG. 13 taken along line III-III'.

Referring to FIG. 14, in the semiconductor package 2003, the package substrate 2100 may be implemented as a printed circuit substrate. The package substrate 2100 may include a package substrate body portion 2120, package upper pads 2130 on an upper surface of the package substrate body portion 2120 (see FIG. 13), lower pads 2125 on the lower surface of the package substrate body portion 2120 or exposed through the lower surface, and internal interconnections 2135 electrically connecting the package upper pads 2130 to the lower pads 2125 in the package substrate body 2120. The lower pads 2125 may be connected to the interconnection patterns 2005 of the main board 2001 of the data storage system 2000 through the conductive connection portions 2800 as shown in FIG. 13.

Each of the semiconductor chips 2200 may include a semiconductor substrate 3010 and a first structure 3100 and a second structure 3200 stacked in order on the semiconductor substrate 3010. The first structure 3100 may include a peripheral circuit region including peripheral interconnections 3110. The second structure 3200 may include a common source line 3205, a gate stack structure 3210 on the common source line 3205, channel structures 3220 penetrating through the gate stack structure 3210, bit lines 3240 electrically connected to the channel structures 3220, and contact plugs 3235 electrically connected to the word lines WL (see FIG. 12) of the gate stack structure 3210. As described above with reference to FIGS. 1 to 9B, the lowermost interlayer insulating layers 120_L forming the second and third stack structures GS2 and GS3 in each of the semiconductor chips 2200 may have a thickness greater than the upper interlayer insulating layers. Also, a level of interfacial surfaces between the first to third contact portions MC1, MC2, and MC3 may be higher than a level of interfacial surfaces between the first to third channel portions CH1, CH2, and CH3.

Each of the semiconductor chips 2200 may include a through-interconnection 3245 electrically connected to the peripheral interconnections 3110 of the first structure 3100 and extending into the second structure 3200. The through-interconnection 3245 may be on an external side of the gate stack structure 3210 and may further be disposed to penetrate through the gate stack structure 3210. Each of the semiconductor chips 2200 may further include an input/output pad 2210 (see FIG. 13) electrically connected to the peripheral interconnections 3110 of the first structure 3100.

According to the aforementioned example embodiments, by optimizing the thickness of the interlayer insulating layers adjacent to the interfacial surface between contact portions forming a contact plug, a semiconductor device having improved mass productivity and reliability and a data storage system including the same may be provided.

By way of summation and review, an example embodiment of the present disclosure may provide a semiconductor device having improved mass productivity and reliability. An example embodiment of the present disclosure may provide a data storage system including a semiconductor device having improved mass productivity and reliability.

Embodiments are set out in the following clauses:
Clause 1. A semiconductor device, comprising:
   a substrate;
   a plate layer;
   gate electrodes and interlayer insulating layers alternately stacked on the plate layer in a first direction perpendicular to an upper surface of the plate layer and forming a first stack structure and a second stack structure on the first stack structure;
   a channel structure penetrating through the gate electrodes and extending in the first direction; and
   a contact plug extending in the first direction and electrically connected to one of the gate electrodes,
   wherein:
      the second stack structure includes a first gate electrode on a lowermost portion, a first interlayer insulating layer on the first gate electrode, and a second interlayer insulating layer on the first interlayer insulating layer, and
      the first interlayer insulating layer has a first thickness, and the second interlayer insulating layer has a second thickness smaller than the first thickness.
Clause 2. The semiconductor device of clause 1, wherein:
   the first stack structure includes a third interlayer insulating layer on an uppermost portion, and
   the third interlayer insulating layer has a third thickness greater than the first thickness.
Clause 3. The semiconductor device of clause 1 or clause 2, wherein:
   the channel structure includes a first channel portion penetrating through the first stack structure and a second channel portion penetrating through the second stack structure,
   the contact plug includes a first contact portion penetrating through the first stack structure and a second contact portion penetrating through at least a portion of the second stack structure, and
   a first interfacial surface between the first channel portion and the second channel portion is on a level different from a level of a second interfacial surface between the first contact portion and the second contact portion.
Clause 4. The semiconductor device of clause 3, wherein the first interfacial surface is on a level lower than a level of an upper surface of the first gate electrode, and the second interfacial surface is on a level higher than the level of the upper surface of the first gate electrode.
Clause 5. The semiconductor device of clause 3 or clause 4, wherein the second interfacial surface is in the first interlayer insulating layer.
Clause 6. The semiconductor device of any of clauses 3-5 wherein the first interfacial surface is on an interfacial surface between the first stack structure and the second stack structure.
Clause 7. A data storage system, comprising:
   a semiconductor storage device including a first semiconductor structure including circuit devices, a second semiconductor structure on one surface of the first semiconductor structure, and an input/output pad electrically connected to the circuit devices; and
   a controller electrically connected to the semiconductor storage device through the input/output pad and configured to control the semiconductor storage device,
   wherein:
      the second semiconductor structure includes:
         a plate layer,
         gate electrodes and interlayer insulating layers alternately stacked on the plate layer in a first direction perpendicular to an upper surface of the plate layer and forming a first stack structure and a second stack structure on the first stack structure,
         a channel structure penetrating through the gate electrodes and extending in the first direction, and
         a contact plug penetrating through the gate electrodes, extending in the first direction, and electrically connected to one of the gate electrodes,
      the channel structure includes a first channel portion penetrating through the first stack structure and a second channel portion penetrating through the second stack structure,
      the contact plug includes a first contact portion penetrating through the first stack structure and a second contact portion penetrating through at least a portion of the second stack structure, and
      a first interfacial surface between the first channel portion and the second channel portion is on a first level, and a second interfacial surface between the first contact portion and the second contact portion is on a second level higher than the first level.
Clause 8. The data storage system of clause 7, wherein:
   the second stack structure includes a first gate electrode on a lowermost portion and a first interlayer insulating layer on the first gate electrode, and
   the second interfacial surface is in the first interlayer insulating layer.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. A semiconductor device, comprising:
a first semiconductor structure including a substrate, circuit devices on the substrate, and circuit interconnection lines on the circuit devices; and
a second semiconductor structure on the first semiconductor structure and having first and second regions,
wherein:
the second semiconductor structure includes:
a plate layer,
gate electrodes stacked and spaced apart from each other on the plate layer in a first direction perpendicular to an upper surface of the plate layer,
interlayer insulating layers alternately disposed with the gate electrodes,
channel structures penetrating through the gate electrodes and the interlayer insulating layers in the first region, extending in the first direction, and each including a channel layer, and
contact plugs penetrating through the gate electrodes and the interlayer insulating layers in the second region, extending in the first direction, and electrically connecting the gate electrodes to a portion of the circuit interconnection lines, respectively,
each of the channel structures includes first and second channel portions stacked in order from a lower portion,
each of the contact plugs includes first and second contact portions stacked in order from a lower portion,
a first interfacial surface between the first channel portion and the second channel portion is on a first level, and a second interfacial surface between the first contact portion and the second contact portion is on a second level higher than the first level, and
the second interfacial surface is in a first interlayer insulating layer among the interlayer insulating layers.

2. The semiconductor device as claimed in claim 1, wherein the first interfacial surface is on a lower surface of a first gate electrode below the first interlayer insulating layer among the gate electrodes.

3. The semiconductor device as claimed in claim 2, wherein:
the gate electrodes and the interlayer insulating layers form a first stack structure surrounding the first channel portion and a second stack structure surrounding the second channel portion, and
the first gate electrode is a lowermost layer of the second stack structure.

4. The semiconductor device as claimed in any preceding claim, wherein:
the interlayer insulating layers further include second interlayer insulating layers on the first interlayer insulating layer, and
the first interlayer insulating layer has a first thickness, and each of the second interlayer insulating layers has a second thickness smaller than the first thickness.

5. The semiconductor device as claimed in claim 4, wherein the first thickness ranges from about 1.5 times to about 2.7 times the second thickness.

6. The semiconductor device as claimed in claim 4 or claim 5, wherein:
the interlayer insulating layers further include a third interlayer insulating layer adjacent to the first interlayer insulating layer below the first interlayer insulating layer, and
the third interlayer insulating layer has a third thickness greater than the first thickness.

7. The semiconductor device as claimed in any preceding claim, wherein:
a width of an upper surface of the first channel portion is greater than a width of a lower surface of the second channel portion, and
a width of an upper surface of the first contact portion is greater than a width of a lower surface of the second contact portion.

8. The semiconductor device as claimed in any preceding claim, wherein, in at least one of the contact plugs, the first contact portion and the second contact portion are shifted from each other in a horizontal direction.

9. The semiconductor device as claimed in any preceding claim, wherein the second contact portion includes an upper region having a width decreasing toward the plate layer and a lower region below the upper region and having a width increasing toward the plate layer.

10. The semiconductor device as claimed in any preceding claim, wherein, in at least one of the contact plugs, the first contact portion has a first diameter on an upper surface, and the second contact portion has a second diameter smaller than the first diameter on an upper surface.

11. The semiconductor device as claimed in any preceding claim, wherein each of the contact plugs includes a vertical extension portion extending in the first direction and a horizontal extension portion extending horizontally from the vertical extension portion and in contact with one of the gate electrodes.

12. The semiconductor device as claimed in any preceding claim, wherein:
in the second region, the gate electrodes form a first step structure of which a level decreases in the first direction and a second step structure of which a level increases in the first direction, and
the contact plugs penetrate through the first step structure.

13. A data storage system, comprising:
a semiconductor device any one of claims 1 to 12, the semiconductor device further including an input/output pad electrically connected to the circuit devices; and
a controller electrically connected to the semiconductor storage device through the input/output pad and configured to control the semiconductor storage device.
